# EUROPEAN PATENT APPLICATION

(11) **EP 4 358 312 A1**
(43) Date of publication of application: **24.04.2024**
(21) Application number: 22855289.9
(22) Date of filing: 03.08.2022
(51) Int. Cl.: H01R 12/57

(54) **CONDUCTIVE ELASTIC CONNECTOR AND ELECTRONIC DEVICE**

(30) Priority: 10.08.2021 CN 202110915228
(71) Applicant: Huawei Technologies Co., Ltd., Shenzhen, Guangdong 518129 (CN)
(72) Inventor: GENG, Yonghong, Shenzhen, Guangdong 518129 (CN); DENG, Hua, Chengdu, Sichuan 610065 (CN); ZHOU, Jianjun, Shenzhen, Guangdong 518129 (CN); ZHANG, Xuezhong, Chengdu, Sichuan 610065 (CN); QIAN, Yungui, Shenzhen, Guangdong 518129 (CN); ZHAO, Guojie, Chengdu, Sichuan 610065 (CN); FU, Qiang, Chengdu, Sichuan 610065 (CN); YU, Zhigang, Shenzhen, Guangdong 518129 (CN)
(74) Representative: Gill Jennings & Every LLP
(86) International application number: PCT/CN2022/109845
(87) International publication number: WO 2023/016306

(57) **Abstract**

To resolve problems that an existing elastic conductive connection component has a narrow working range and a high frequency spurious is easily generated, embodiments of this application provide an elastic conductive connection component having an inner hole and having a nanowire attached to the inner hole. The elastic conductive connection component is configured to connect a first element and a second element, and the elastic conductive connection component includes a foam and the nanowire. The foam has a first surface and a second surface that are disposed opposite to each other in a first direction. The first surface is configured to be electrically connected to the first element, and the second surface is electrically connected to the second element. The foam includes an inner hole. The nanowire is attached to a hole wall of the inner hole. The elastic conductive connection component in embodiments of this application uses the foam that has the inner hole and has the nanowire attached to the inner hole. Because the nanowire is attached to the inner hole, ground resistance can be remained in low resistance. In addition, due to the inner hole in the foam, when the elastic conductive connection component is compressed, a force (or a rebound force) slowly increases, and a working range of the elastic conductive connection component is broadened. In addition, because a uniform nanowire is formed on the hole wall of the inner hole of the foam as a conducting layer, the conducting layer has better stability than an electroplating layer formed by a conventional process. The nanowire conducting layer is not prone to break and fall off, and a high frequency spurious can be avoided. Therefore, the elastic conductive connection component in embodiments of this application has an advantage of a low frequency spurious.

## Description

This application claims priority to Chinese Patent Application No. 202110915228.3, filed with the China National Intellectual Property Administration on August 10, 2021 and entitled "ELASTIC CONDUCTIVE CONNECTION COMPONENT AND ELECTRONIC DEVICE", which is incorporated herein by reference in its entirety.

### TECHNICAL FIELD

This application relates to the field of conductive connection components, and in particular, to an elastic conductive connection component and an electronic device including the elastic conductive connection component.

### BACKGROUND

To improve working performance of an electronic device, reduce radio frequency interference between components, increase isolation between components, reduce electron electrostatic risks, and the like, the electronic device usually needs to be grounded, and a component in the electronic device also needs to be grounded. For example, a camera module needs to be grounded to avoid interference from a radio frequency signal from an antenna, and a display assembly also needs to be grounded to avoid electromagnetic noise affecting normal operation of the display assembly. Generally, the antenna, the display assembly, or the camera module is grounded by using an elastic conductive connection component. The elastic conductive connection component features as compression rebound, and may generate a specific force (a rebound force) to stably connect components. In addition, the elastic conductive connection component has conductivity, and may implement electromagnetic shielding or an electrical connection.

Functions of the electronic device are diversified, components included in the electronic device are also diversified, a quantity of components increases, and space in the electronic device is very limited. Therefore, an elastic conductive connection component is required to implement electrical connections between different components or ground different components.

### SUMMARY

To resolve problems that an existing elastic conductive connection component has a narrow working range and a high frequency harmonic wave is easily generated, embodiments of this application provide an elastic conductive connection component structure having an inner hole and having a nanowire attached to the inner hole. The elastic conductive connection component features as a low frequency spurious and has a wide working range, and may be used to implement electrical connections between different components or ground different components.

According to a first aspect, an embodiment of this application provides an elastic conductive connection component having an inner hole and having a nanowire attached to a hole wall of the inner hole. The elastic conductive connection component is configured to connect a first element to a second element, and the elastic conductive connection component includes a foam and a nanowire, where the foam has a first surface and a second surface that are disposed opposite to each other in a first direction. The first surface is configured to be electrically connected to the first element, the second surface is electrically connected to the second element, the foam includes the inner hole, and the nanowire is attached to the hole wall of the inner hole.

The elastic conductive connection component in this embodiment of this application uses a foam (for example, formed by using a coating process) having an inner hole and a nanowire is attached to the inner hole. Because a conductive nanowire is attached to the inner hole, ground resistance can be remained in low resistance. In addition, due to the inner hole in the foam, when the elastic conductive connection component is compressed, a force (or a rebound force) slowly increases, and a working range of the elastic conductive connection component is broadened.

In addition, because a uniform nanowire is formed on the hole wall of the inner hole of the foam as the conducting layer, the conducting layer has better stability than an electroplating layer formed by a conventional process. A conducting layer of the nanowire is not prone to break and fall off, and a high frequency spurious can be avoided. Therefore, the elastic conductive connection component in embodiments of this application has an advantage of a low frequency spurious.

With reference to the first aspect, in a possible implementation, the inner hole includes a closed hole.

Because the closed hole is surrounded by the hole wall, air and moisture cannot enter the inner hole. The closed hole can enhance rigidity and stability of the elastic conductive connection component, and avoid damage of the elastic conductive connection component by a force.

With reference to the first aspect, in a possible implementation, the inner hole includes an opening hole.

The opening hole is not connected by using the foam, and inner holes are not communicated with each other, thereby allowing gas to flow between the holes. This enables the conductive elastic connecting to become a softer and more flexible material, enhance its bending capacity and expands its compression range.

With reference to the first aspect, in a possible implementation, the inner hole includes an opening hole and a closed hole.

The elastic conductive connection component in this embodiment of this application includes both the opening hole and the closed hole, and may have advantages of both the opening hole and the closed hole. In addition to rigidity and stability, the elastic conductive connection component may further have flexibility and flexibility.

With reference to the first aspect, in a possible implementation, the inner hole includes an opening hole and a closed hole, where the closed hole is located in two-side regions along a width direction, and the opening hole is located between the two-side regions.

By disposing closed-hole regions on both sides along the width W direction, and disposing open-hole regions between the closed-hole regions along the width W direction, the two sides along the width W direction can be rigid and stable, and a connection between the connecting piece and the first element and the second element is stable and does not fall off. At the same time, the connecting piece has sufficient flexibility in a main connection region (for example, a middle region of a section of the elastic conductive connection component along the width W direction), to ensure that the elastic conductive connection component has a wide working range.

With reference to the first aspect, in a possible implementation, the inner hole includes inner hole structures of at least two sizes.

Because the size of the inner hole affects a compressible range of the foam, by opening inner holes of different sizes in the foam, the elastic conductive connection component can have different compression ranges in different regions.

With reference to the first aspect, in a possible implementation, a diameter of the inner hole is 20 um to 500 um.

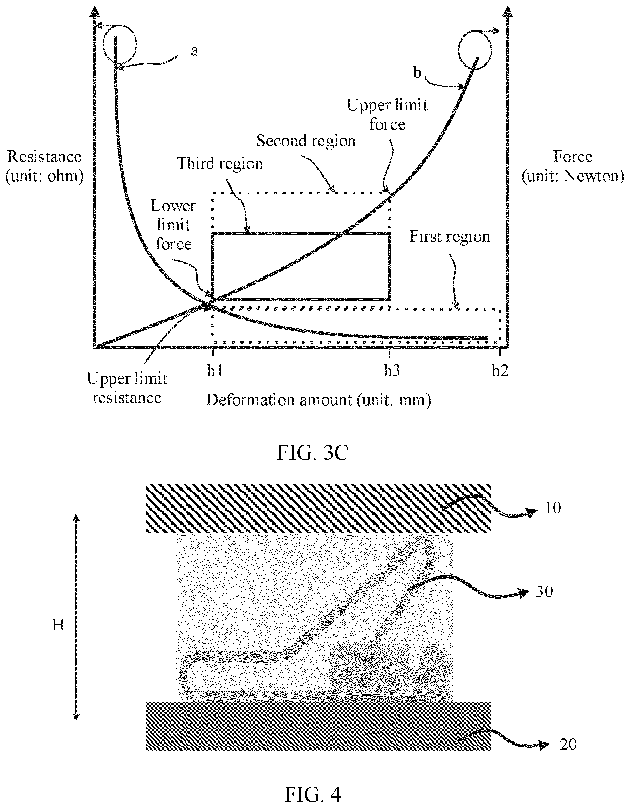

The diameter of the inner hole is 20 um to 500 um, so that a conductive elastomer has a low density, and a force (or a rebound force) generated after the foam is compressed increases slowly, so that a deformation amount corresponding to an upper limit force of the foam can be ensured to be larger, so as to expand the compressible range of the foam to meet a force demand (for example, a compression range of a second region in FIG. 3C) and broaden the working range of the elastic conductive connection component.

With reference to the first aspect, in a possible implementation, a diameter of the foam after opening is 100 um.

The diameter of the inner hole is set to 100 um, so that the foam has a wide resilient working range, and can also have rigidity and stability, to avoid force damage.

With reference to the first aspect, in a possible implementation, a density of the elastic conductive connection component with the inner hole is less than or equal to 200 kg/m².

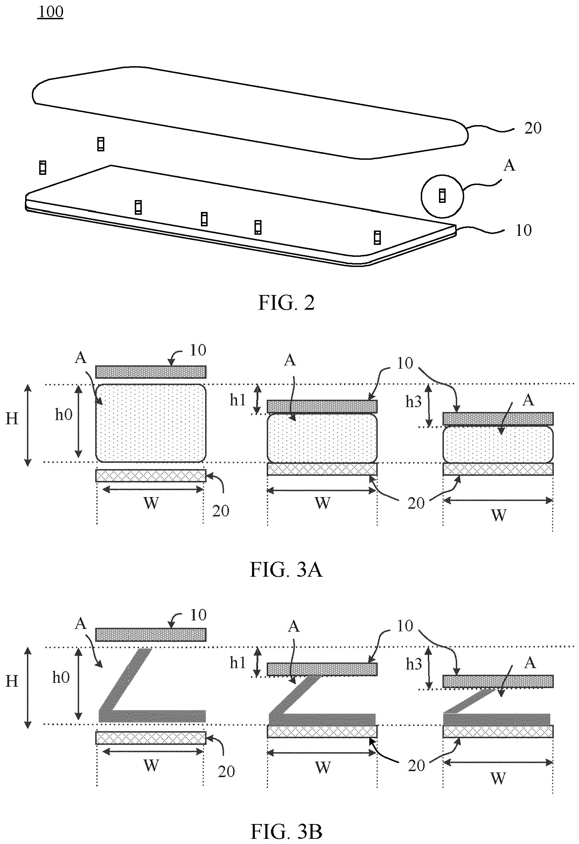

By opening the inner hole, the density of the elastic conductive connection component after the inner hole is opened is less than or equal to 200 kg/m², and a force (or a rebound force) generated after the foam is compressed increases slowly, so that a deformation amount corresponding to an upper limit force of the foam can be ensured to be larger, so as to expand the compressible range of the foam to meet a force demand (for example, a compression range of a second region in FIG. 3B) and broaden the working range of the elastic conductive connection component.

With reference to the first aspect, in a possible implementation, a diameter of the nanowire is between 10 nm and 100 nm.

By controlling the diameter of the nanowire to be between 10 nm and 100 nm, the nanowire can be firmly attached to the hole wall of the inner hole and is not prone to fall off, and high frequency spurious caused by the nanowire falling off under a force is avoided. In addition, by setting a diameter range to be between 10 nm and 100 nm, low ground resistance can be obtained.

With reference to the first aspect, in a possible implementation, the diameter of the nanowire is less than or equal to 70 nm.

When the diameter of the nanowire is less than or equal to 70 nm, conductivity of the elastic conductive connection component can be enhanced, the nanowire can be prevented from falling off due to a force on the foam, and a high frequency spurious can be avoided.

With reference to the first aspect, in a possible implementation, a ratio of a length to the diameter of the nanowire ranges from 1000: 1 to 5000: 1.

The ratio of the length to the diameter of the nanowire ranges from 1000:1 to 5000:1, so that the nanowire attached to the hole wall can be prevented from breaking after being compressed, so that the nanowire has rigidity and stability, and a high frequency spurious can be avoided.

With reference to the first aspect, in a possible implementation, the nanowire is at least one of a silver nanowire, a copper nanowire, a carbon nanowire, and a gold nanowire.

By adopting the silver nanowire, the copper nanowire, the carbon nanowire, and the gold nanowire, the conductive elastomer can be ensured to have good conductivity and low resistance.

With reference to the first aspect, in a possible implementation, the elastic conductive connection component further includes a conductive fabric, the conductive fabric covers a surface of the foam, and the surface of the foam includes the first surface and the second surface that are disposed opposite to each other in the first direction of the foam.

The conductive fabric is wrapped in the foam of the elastic conductive connection component, and this can enhance conductivity and reduce the ground resistance. In addition, a risk of increased ground resistance due to a fracture of the nanowire can also be reduced. For example, when the deformation amount exceeds a specific value, the nanowire may break or even fall off, and the surface is coated with a conducting layer, which can avoid a problem of ground resistance instability caused by the nanowire that may break or even fall off.

With reference to the first aspect, in a possible implementation, the first surface and the second surface are electrically connected through a through hole, a hole wall of the through hole is attached with a metal conducting layer or attached with the nanowire.

The elastic conductive connection component is electrically connected to the first surface and the second surface along a height H direction through a through hole 704. A metal conducting layer is attached to the through hole 704 through electroplating or electroless plating, or the nanowire is attached to the through hole, so that conductivity of the elastic conductive connection component can be enhanced, to avoid the problem of unstable ground resistance caused by the fracture and falling off of the nanowire on the hole wall.

With reference to the first aspect, in a possible implementation, the foam is a mesh structure, and a metal conducting layer is attached to the mesh structure.

The foam of the elastic conductive connection component is a metallization foam, where the metallization foam is formed in a form of electroplating or electroless plating, which can enhance conductivity of the elastic conductive connection component, and avoid a problem of unstable ground resistance caused by the fracture and falling off of the nanowire on the hole wall of the inner hole.

According to a second aspect, an embodiment of this application provides an electronic device. The electronic device includes a first element, a second element, and the elastic conductive connection component according to any one of the first aspect or the possible manners of the first aspect.

With reference to the second aspect, in a possible implementation, the electronic device further includes a conductive adhesive, and the conductive adhesive is disposed between a first surface and the first element, and/or the conductive adhesive is disposed between a second surface and the second element.

Optionally, the conductive adhesive may be a force-sensitive adhesive.

Optionally, the conductive adhesive is doped with a conductive particle, and the conductive particle is one or a combination of gold, silver, copper, aluminum, zinc, iron, and nickel.

Optionally, the conductive adhesive may alternatively be doped with a nanowire, and the nanowire may be one or a combination of gold, silver, copper, aluminum, zinc, iron, and nickel.

By doping the nanowire in the conductive adhesive, the conductive adhesive can be viscous and ground resistance can be reduced.

With reference to the second aspect, in a possible implementation, the first element includes a middle frame, the middle frame is grounded, the electronic device includes the elastic conductive connection component provided in the first aspect, and the second element is electrically connected to the second element through the elastic conductive connection component to implement grounding.

By using the elastic conductive connection component provided in this embodiment of this application, ground resistance when the elastic conductive connection component is connected to a component can be reduced, and stability of low ground resistance can be improved, thereby avoiding non-linear introduction of other radiation spurious emission. For example, in a scenario in which an antenna is grounded, usage performance of the antenna can be ensured, anti-interference performance between the antenna and another component can be improved, and usage reliability of an electronic device can be improved.

With reference to the second aspect, in a possible implementation, the second component includes a display assembly, the elastic conductive connection component is disposed between the display assembly and the middle frame. The second surface of the elastic conductive connection component is electrically connected to the display assembly. The first surface of the elastic conductive connection component is fixed and electrically connected to the middle frame, so that the display assembly is grounded through the elastic conductive connection component.

With reference to the second aspect, in a possible implementation, the second component includes a camera module, the elastic conductive connection component is disposed between the camera module and the middle frame. The second surface of the elastic conductive connection component is electrically connected to the camera module. The first surface of the elastic conductive connection component is fixed and electrically connected to the middle frame, so that the camera module is grounded through the elastic conductive connection component.

With reference to the second aspect, in a possible implementation, the second component includes a shielding cover, the elastic conductive connection component is disposed between the shielding cover and the middle frame. The second surface of the elastic conductive connection component is electrically connected to the shielding cover. The first surface of the elastic conductive connection component is fixed and electrically connected to the middle frame, so that the shielding cover is grounded through the elastic conductive connection component.

With reference to the second aspect, in a possible implementation, the second component includes an antenna part, the elastic conductive connection component is disposed between the antenna part and the middle frame. The first surface of the elastic conductive connection component is electrically connected to the antenna part. The first surface of the elastic conductive connection component is fixed and electrically connected to the middle frame, so that the shielding cover is grounded through the elastic conductive connection component.

According to a third aspect, an embodiment of this application provides a preparation method of an elastic conductive connection component. The preparation method includes the following steps:
prepare nanowire solution;
select a foam with an inner hole;
drop-coat/coat the nanowire solution onto the foam with the inner hole, or immerse the foam with the inner hole into the nanowire solution;
dry and solidify the elastic conductive connection component at 50°C to 70°C for 2 minutes to 20 minutes; and
bake the elastic conductive connection component at 70°C for 30 minutes.

According to a fourth aspect, an embodiment of this application provides a preparation method of a surface-mountable elastic conductive connection component. The preparation method includes the following steps:
prepare nanowire solution;
select a foam with an inner hole;
drop-coat/coat the nanowire solution onto the foam with the inner hole, or immerse the foam with the inner hole into the nanowire solution;
coat solderable nanowire solution on the elastic conductive connection component;
dry and solidify the elastic conductive connection component with the surface coated with the solderable nanowire solution at 50°C to 70°C for 2 minutes to 20 minutes; and
bake the elastic conductive connection component coated with the solderable nanowire solution at 70°C for 30 minutes.

By coating the solderable nanowire solution on the foam, the elastic conductive connection component can be surface mounted, and can be soldered to a main board for grounding the main board.

### BRIEF DESCRIPTION OF DRAWINGS

FIG. 1 is a schematic diagram of a hardware architecture of an electronic device according to an embodiment of this application;
FIG. 2 is a schematic connection diagram of an elastic conductive connection component according to an embodiment of this application;
FIG. 3A and FIG. 3B are schematic diagrams of an elastic conductive connection component according to an embodiment of this application;
FIG. 3C is a curve diagram of a relationship between a deformation amount, resistance, and a force of an elastic conductive connection component according to an embodiment of this application;
FIG. 4 is a schematic cross-sectional view of a spring plate;
FIG. 5 is a schematic cross-sectional view of FOF gaskets;
FIG. 6 is a schematic cross-sectional view of perforated gaskets;
FIG. 7A is a schematic cross-sectional view of fabric over gaskets;
FIG. 7B is a partial electron micrograph of fabric over gaskets;
FIG. 8 is a schematic cross-sectional view of an elastic conductive connection component according to an embodiment of this application;
FIG. 9 is a schematic diagram of an inner hole coated with a nanowire in an elastic conductive connection component according to an embodiment of this application;
FIG. 10 is another schematic cross-sectional view of an elastic conductive connection component according to an embodiment of this application;
FIG. 11 is another schematic cross-sectional view of an elastic conductive connection component according to an embodiment of this application;
FIG. 12 is another schematic cross-sectional view of an elastic conductive connection component according to an embodiment of this application;
FIG. 13 is another schematic cross-sectional view of an elastic conductive connection component according to an embodiment of this application;
FIG. 14 is another schematic cross-sectional view of an elastic conductive connection component according to an embodiment of this application;
FIG. 15 is a photo of a part of an elastic conductive connection component under an electron microscope according to an embodiment of this application;
FIG. 16 is a curve diagram of a relationship between a deformation amount, resistance, and a force of an elastic conductive connection component according to an embodiment of this application;
FIG. 17 is a curve diagram of a relationship between a frequency spurious and a deformation amount of an elastic conductive connection component according to an embodiment of this application;
FIG. 18 is a preparation method of an elastic conductive connection component according to an embodiment of this application; and
FIG. 19 is another preparation method of an elastic conductive connection component according to an embodiment of this application.

### DESCRIPTION OF EMBODIMENTS

To make objectives, technical solution, and advantages of this application clearer, the following further describes this application in detail with reference to the accompanying drawings.

The following describes the technical solutions in embodiments of this application with reference to the accompanying drawings in embodiments of this application. In the descriptions of embodiments of this application, unless otherwise specified, "/" represents "or". For example, A/B may represent A or B. The term "and/or" in this specification is merely an association relationship for describing associated objects, and indicates that three relationships may exist. For example, A and/or B may represent the following three cases: Only A exists, both A and B exist, and only B exists. In addition, in the descriptions of embodiments of this application, "a plurality of" means two or more.

The following terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments of this application, unless otherwise specified, "a plurality of" means two or more than two.

The terms used in the descriptions of the invention herein are for the purpose of describing specific embodiments only, and are not intended to be a limitation on the invention.

In addition, in this application, position terms such as "upper", "lower", "front", and "rear" are defined relative to positions in which components in the accompanying drawings are schematically placed. It should be understood that these position terms are relative concepts, are used for description and clarification of "relative to", and may vary according to a change in the positions in which the components in the accompanying drawings are placed.

It should be noted that "electrical connection" in embodiments of this application should be understood in a broad sense, and may include a physical direct connection, or may include a coupling connection by using a capacitor, a conductive fabric, or a conductive adhesive (or another material), or may include a combination of a coupling connection and physical direct connection.

It should be further noted that the descriptions of shapes such as "rectangular" and "circular" in embodiments of this application may include an approximate shape. In consideration of an actual manufacturing error, the approximate shape also falls within the range described in embodiments of this application.

This application relates to an elastic conductive connection component, an electronic device, and a preparation method of the elastic conductive connection component. The following briefly describes concepts involved in this application.

A foam is a material obtained after plastic particles, silica gel particles or rubber particles are foamed and molded. The foam includes but is not limited to polyurethane (polyurethane, PU) gaskets, silica gel gaskets, polyethylene (polyethylene, PE) gaskets, and polypropylene (polypropylene, PP) gaskets, styrene-butadiene rubber gaskets, acrylic gaskets, vinyl acetate gaskets, vinylidene chloride gaskets, nitrile gaskets, silicone gaskets, acrylamide gaskets, natural rubber gaskets, polyvinyl chloride gaskets, polysulfide rubber gaskets, Styrene-acrylate copolymer gaskets, vinyl acetate-acrylate copolymer gaskets, silicone-acrylate copolymer gaskets and modified silicone-acrylate copolymer gaskets.

Foaming is a process of making plastic, silica gel or rubber produce a microporous structure. In a foaming and molding process or foaming polymer material, through addition and reaction of a physical foaming agent or chemical foaming agent, a honeycomb or porous structure is formed.

A foaming agent is also known as a foaming material, refers to a material that can gasify inside plastic, silica gel or rubber to produce bubbles and make it into a porous material. The foaming agent includes but is not limited to, azo compounds, sulfonyl hydrazide compounds, nitroso compounds, sodium bicarbonate, sodium carbonate, n-pentane, n-hexane, n-heptane, petroleum ether (also known as naphtha), trichlorofluoromethane, dichlorodi Fluoromethane and dichlorotetrafluoroethane.

A component is an electronic element and small components, is usually composed of several parts and can be used in a same type of product. The component includes but is not limited to a camera module, a display assembly, a sensor, and an earpiece. Some components (such as a camera and a display) that are susceptible to electromagnetic interference signals have shielding covers, and the shielding covers are connected to a reference ground through the elastic conductive connection component, so that signal shielding can be implemented.

Electrostatic: An electrostatic phenomenon is a common phenomenon in people's life. It refers to charge converged on a surface of an object. The convergence of electrostatic makes the surface of the object produce a high potential. As the electronic device has more functions, a circuit inside the electronic device is closer to a surface of the electronic device. Electrostatic on the surface of the electronic device or electrostatic on a surface of an external object may enter the electronic device through a gap on the surface of the electronic device, and this affects normal operation of electronic parts and components.

Electromagnetic interference (Electromagnetic Interference, EMI): There are two types of interference: conducted interference and radiated interference. The conducted interference refers to coupling a signal from an electrical network to another electrical network through a conductive medium. The radiated interference means that an interference source couples its signal to another electrical network through space. The electromagnetic interference in embodiments of this application refers to the radiated interference. In high-speed printed circuit board (printed circuit board, PCB) and system design, a high-frequency signal line, a pin of an integrated circuit, various connectors, and the like may become a radiation interference source with an antenna characteristic, and can emit electromagnetic waves and affect normal operation of another system or another subsystem in the system.

Working range: As shown in FIG. 3C, a working range of the elastic conductive connection component is a range of a horizontal coordinate (a deformation amount) corresponding to a third region. In this embodiment of this application, a compression range of the elastic conductive connection component corresponding to the third region that meets resistance and a force requirement is defined as the working range of the elastic conductive connection component.

As functions of a mobile phone become more abundant, an antenna on the mobile phone covers more frequency bands, but thickness of the entire mobile phone becomes smaller, and a grounding requirement in a radio frequency field becomes more important. An antenna clutter problem needs to be resolved, antenna performance needs to be improved. In addition, electromagnetic interference between components or modules needs to be reduced, an anti-interference capability of components needs to be improved, and an EMC (Electromagnetic Compatibility) problem needs to be considered. For example, when an antenna receives or sends a signal, a screen flickers easily due to interference from a radio frequency signal, or a camera module is easily interfered by a radio frequency signal. In addition, ESD (electrostatic discharge, Electrostatic discharge) is also a problem that needs to be resolved. For example, for an antenna, non-linear introduction of other spurious radiation needs to be avoided, so as to ensure radiation performance of the antenna.

To reduce the radio frequency interference between components, increase isolation between the components, reduce a risk of a component damage caused by the ESD, and improve the working performance of the components (for example, improving working performance of an antenna and the display assembly), a radio frequency terminal device needs to be grounded. For example, the camera module needs to be grounded, the antenna module needs to be grounded, and a rear cover or a middle frame of the electronic device needs to be grounded.

In an electronic device like a mobile phone, a television, a display, a laptop computer, a palmtop computer, or an in-vehicle navigation system, a component that needs to be grounded is usually grounded by using an elastic conductive connection component. The grounding includes connecting to the reference ground. It should be understood that the component includes a shielding cover or a shielding can that is on the electronic device and that is used for grounding.

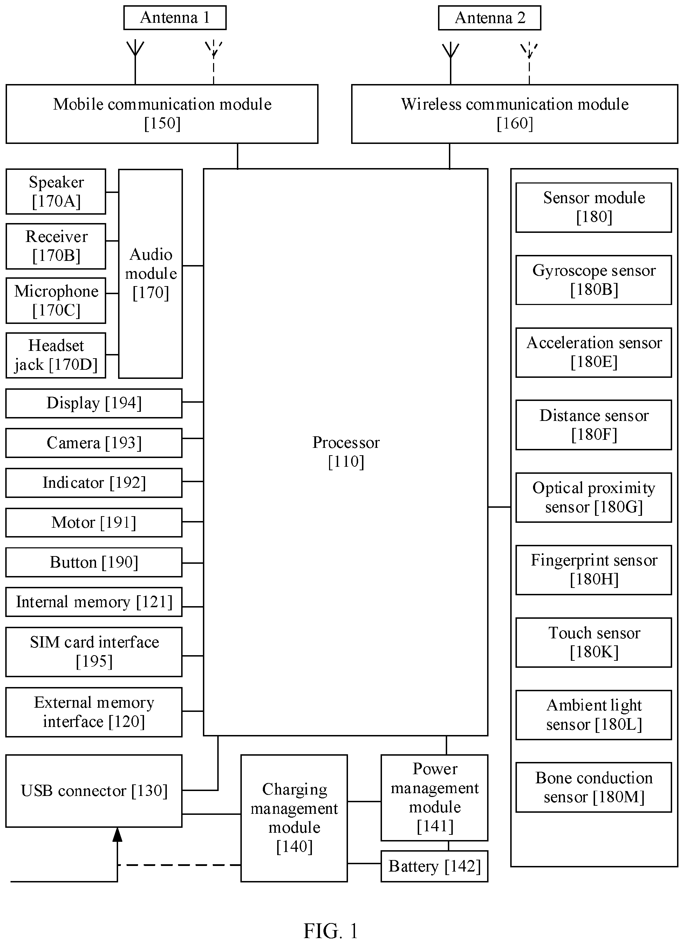

FIG. 1 is a schematic diagram of a structure of an electronic device 100 that includes adisplay assembly, a camera module, and an antenna.

The electronic device 100 may include at least one of a mobile phone, a foldable electronic device, a tablet computer, a home screen computer, a laptop computer, a handheld computer, a laptop computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a wearable device, a vehicle-mounted device, a smart home device, or a smart city device. A specific type of the electronic device 100 is not specially limited in this embodiment of this application.

The electronic device 100 may include a processor 110, an external memory interface 120, an internal memory 121, a universal serial bus (universal serial bus, USB) connector 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identity module (subscriber identity module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It may be understood that the structure shown in this embodiment of this application does not constitute a specific limitation on the electronic device 100. In some other embodiments of this application, the electronic device 100 may include more or fewer components than those shown in the figure, or some components may be combined, or some components may be split, or different component arrangements may be used. The illustrated components may be implemented in hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors. In some embodiments, the processor may include a first processor 1101 (for example, a cooperative processor) and a second processor 1102 (for example, an application processor).

The processor may generate an operation control signal based on an instruction operation code and a time sequence signal, to complete control of instruction reading and instruction execution.

A memory may be further disposed in the processor 110, and is configured to store instructions and data. In some embodiments, the memory in the processor 110 may be a cache memory. The memory may store an instruction or data that is used or frequently used by the processor 110. If the processor 110 needs to use the instruction or the data, the processor 110 may directly invoke the instruction or the data from the memory. This avoids repeated access, reduces waiting time of the processor 110, and improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like. The processor 110 may be connected to a module like a touch sensor, an audio module, a wireless communication module, a display, and a camera through at least one of the foregoing interfaces.

It may be understood that an interface connection relationship between the modules shown in this embodiment of this application is merely an example for description, and does not constitute a limitation on the structure of the electronic device 100. In some other embodiments of this application, the electronic device 100 may alternatively use different interface connection manners or a combination of a plurality of interface connection manners in the foregoing embodiment.

The USB connector 130 is an interface that complies with a USB standard specification, and may be configured to connect the electronic device 100 and a peripheral device. Specifically, the USB connector 130 may be a Mini USB connector, a Micro USB connector, a USB Type C connector, or the like. The USB connector 130 may be configured to connect to a charger, so that the charger charges the electronic device 100, or may be configured to connect to another electronic device, so as to implement data transmission between the electronic device 100 and the another electronic device, or may be configured to connect to a headset, and output, through the headset, audio stored in the electronic device. The connector may be further configured to connect to the another electronic device like a VR device. In some embodiments, standard specifications of the universal serial bus may be USB 1.x, USB 2.0, USB 3.x, and USB 4.

The charging management module 140 is configured to receive charging input of the charger. The charger may be a wireless charger, or may be a wired charger. In some embodiments of wired charging, the charging management module 140 may receive charging input from the wired charger through the USB connector 130. In some embodiments of wireless charging, the charging management module 140 may receive wireless charging input through a wireless charging coil of the electronic device 100. When charging the battery 142, the charging management module 140 may further supply power to the electronic device by using the power management module 141. In some embodiments, the charging management module 140 needs to be set grounded. Alternatively, a shielding cover needs to be added to the charging management module 140, and the shielding cover is set grounded. In this way, mutual interference between the charging management module 140 and another module (for example, an antenna or a radio frequency component) can be avoided.

The power management module 141 is configured to connect the battery 142, the charging management module 140, and the processor 110. The power management module 141 receives input from the battery 142 and/or the charging management module 140, and supplies power to the processor 110, the internal memory 121, the display 194, the camera 193, the wireless communication module 160, and the like. The power management module 141 may be further configured to monitor parameters such as a battery capacity, a quantity of battery cycles, and a battery health status (electric leakage or resistance). In some other embodiments, the power management module 141 may also be disposed in the processor 110. In some other embodiments, the power management module 141 and the charging management module 140 may also be disposed in a same component.

A wireless communication function of the electronic device 100 may be implemented through the antenna 1, the antenna 2, the mobile communication module 150, the wireless communication module 160, the modem processor, the baseband processor, and the like.

The antenna 1 and the antenna 2 are configured to transmit and receive electromagnetic wave signals. Each antenna in the electronic device 100 may be configured to cover one or more communication frequency bands. Different antennas may be further multiplexed to improve antenna utilization. For example, the antenna 1 may be multiplexed as a diversity antenna of a wireless local area network. In some other embodiments, the antenna may be used in combination with a tuning switch.

The mobile communication module 150 may provide a wireless communication solution that is applied to the electronic device 100 and includes a 2G/3G/4G/5G or the like. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules in the mobile communication module 150 may be disposed in the processor 110. In some embodiments, at least some functional modules of the mobile communication module 150 may be disposed in a same component as at least some modules of the processor 110.

The modem processor may include a modulator and a demodulator. The modulator is configured to modulate a to-be-sent low-frequency baseband signal into a medium-high frequency signal. The demodulator is configured to demodulate the received electromagnetic wave signal into the low-frequency baseband signal. Then, the demodulator transmits the demodulated low-frequency baseband signal to the baseband processor for processing. The low-frequency baseband signal is processed by the baseband processor and then transferred to the application processor. The application processor outputs a sound signal through an audio device (which is not limited to the speaker 170A, the receiver 170B, or the like), or displays an image or a video through the display 194. In some embodiments, the modem processor may be an independent component. In some other embodiments, the modem processor may be independent of the processor 110, and is disposed in a same component as the mobile communication module 150 or another function module.

The wireless communication module 160 may provide a wireless communication solution that includes a wireless local area network (wireless local area network, WLAN) (for example, a wireless fidelity (wireless fidelity, Wi-Fi) network), Bluetooth (Bluetooth, BT), Bluetooth low energy (Bluetooth low energy, BLE), ultra-wideband (ultra-wideband, UWB), a global navigation satellite system (global navigation satellite system, GNSS), frequency modulation (frequency modulation, FM), a near field communication (near field communication, NFC) technology, an infrared (infrared, IR) technology, or the like and that is applied to the electronic device 100. The wireless communication module 160 may be one or more components integrating at least one communication processor module. The wireless communication module 160 receives an electromagnetic wave through the antenna 2, performs frequency modulation and filtering processing on an electromagnetic wave signal, and sends a processed signal to the processor 110. The wireless communication module 160 may further receive a to-be-sent signal from the processor 110, perform frequency modulation and amplification on the signal, and convert the signal into an electromagnetic wave for radiation through the antenna 2.

In some embodiments, the antenna 1 of the electronic device 100 is coupled to the mobile communication module 150, and the antenna 2 is coupled to the wireless communication module 160, so that the electronic device 100 can connect to a network and another electronic device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-CDMA), long term evolution (long term evolution, LTE), BT, a GNSS, the WLAN, the NFC, the FM, the IR technology, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation system, SBAS).

In some embodiments, the antenna 1 and the antenna 2 need to be set grounded. A radiation function of the antenna is implemented. In addition, electromagnetic radiation generated by the antenna is prevented from being coupled to another module to cause interference. For example, the electromagnetic radiation generated by the antenna is easily coupled to the display or the camera module, and this affects normal operation of the display or the camera module. It should be understood that, in some embodiments, the antenna 1 and/or the antenna 2 may be installed in an electronic device in a form of an antenna module, where the module includes an antenna and a radio frequency integrated circuit.

The electronic device 100 may implement a display function by using the GPU, the display 194, the application processor, or the like. The GPU is a microprocessor for image processing, and is connected to the display 194 and the application processor. The GPU is used to perform mathematical and geometric calculations, and render an image. The processor 110 may include one or more GPUs that execute program instructions to generate or change display information.

The display 194 is configured to display an image, a video, or the like. The display 194 includes a display panel. The display panel may be a liquid crystal display (liquid crystal display, LCD), an organic light-emitting diode (organic light-emitting diode, OLED), an active-matrix organic light-emitting diode (active-matrix organic light emitting diode, AMOLED), a flexible light-emitting diode (flex light-emitting diode, FLED), a mini-LED, a micro-LED, a micro-OLED, a quantum dot light-emitting diode (quantum dot light-emitting diode, QLED), or the like. In some embodiments, the electronic device 100 may include one or more displays 194.

In some embodiments, the display 194 needs to be set grounded. Through the grounding setting, an anti-interference capability of the display 194 can be enhanced, and noise caused by electromagnetic interference to cause abnormal display of the display can be avoided.

The electronic device 100 may implement an image shooting function by using the camera 193, the ISP, the video codec, the GPU, the display 194, the application processor AP, a neural network processor NPU, and the like.

The camera module 193 may be configured to collect color image data and depth data of a photographed object. The ISP may be configured to process the color image data collected by the camera module 193. For example, during image shooting, a shutter is opened, and light is transferred to a photosensitive element of the camera through a lens. An optical signal is converted into an electrical signal, and the photosensitive element of the camera transfers the electrical signal to the ISP for processing, to convert the electrical signal into a visible image. The ISP may further optimize parameters such as exposure and a color temperature of an image shooting scenario. In some embodiments, the ISP may be disposed in the camera module 193.

In some embodiments, the camera module 193 may include a color camera module and a 3D sensing module.

In some embodiments, a photosensitive element of a camera of the color camera module may be a charge coupled device (charge coupled device, CCD) or a complementary metal-oxide-semiconductor (complementary metal-oxide-semiconductor, CMOS) photoelectric transistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format like RGB or YUV

In some embodiments, the 3D sensing module may be a (time of flight, TOF) 3D sensing module or a structured light (structured light) 3D sensing module. Structured light 3D sensing is an active depth sensing technology, and basic components of the structured light 3D sensing module may include an infrared (Infrared) emitter, an IR camera module, and the like. A working principle of the structured light 3D sensing module is to first emit a light spot of a specific pattern (pattern) to a photographed object, and then receive light coding (light coding) of a light spot on a surface of the object, so as to compare a similarity and a difference between the light spot and an original projection light spot. Three-dimensional coordinates of the object are calculated by using a triangle principle. The three-dimensional coordinates include a distance between the electronic device 100 and the photographed object. The TOF 3D sensing may be an active depth sensing technology, and basic components of the TOF 3D sensing module may include an infrared (Infrared) emitter, an IR camera module, and the like. A working principle of the TOF 3D sensing module is to calculate the distance (namely, depth) between the TOF 3D sensing module and the photographed object by using infrared refraction time to obtain a 3D depth-of field image.

The structured light 3D sensing module may also be used in the fields of somatic game console, and industrial machine vision detection, and the like. The TOF 3D sensing module may also be applied to the fields of a game console, augmented reality (augmented reality, AR)/virtual reality (virtual reality, VR), and the like.

In some other embodiments, the camera module 193 may further include two or more cameras. The two or more cameras may include a color camera, and the color camera may be configured to collect color image data of a photographed object. The two or more cameras may use a stereo vision (stereo vision) technology to collect depth data of the photographed object. The stereo vision technology is based on a principle of human eye parallax. Under a natural light source, two or more cameras are used to shoot images from different angles on a same object, and then a mathematical operation like triangulation is performed to obtain distance information, namely, depth information, between the electronic device 100 and the photographed object.

In some embodiments, the electronic device 100 may include one or more camera modules 193. Specifically, the electronic device 100 may include one front-facing camera module 193 and one rear-facing camera module 193. The front-facing camera module 193 may be generally configured to collect color image data and depth data of a photographer facing the display 194, and the rear-facing camera module may be configured to collect color image data and depth data of a photographed object (like a person or a landscape) facing the photographer.

In some embodiments, the CPU, the GPU, or the NPU in the processor 110 may process the color image data and the depth data that are collected by the camera module 193. In some embodiments, the NPU may identify, by using a neural network algorithm like a convolutional neural network algorithm (CNN) based on by a skeleton point identification technology, the color image data collected by the camera module 193 (specifically, the color camera module), to determine a skeleton point of a photographed person. The CPU or GPU may also run the neural network algorithm to determine the skeleton point of the photographed person based on the color image data. In some embodiments, the CPU, the GPU, or the NPU may be further configured to determine a body (for example, a body proportion, fat and thin conditions of body parts between skeleton points) of the photographed person based on the depth data collected by the camera module 193 (which may be the 3D sensing module) and an identified skeleton points, and may further determine a body beautification parameter for the photographed person, and finally process a photographed image of the photographed person according to the body beautification parameter, so that a body shape of the photographed person in the photographed image is beautified.

The digital signal processor is configured to process a digital signal, and may also process another digital signal. For example, when the electronic device 100 selects a frequency, the digital signal processor is configured to perform Fourier transform on frequency energy, and the like.

The video codec is used to compress or decompress digital video. The electronic device 100 may support one or more video codecs. In this way, the electronic device 100 may play or record videos in a plurality of encoding formats, for example, moving picture experts group (moving picture experts group, MPEG) 1, MPEG 2, MPEG 3, and MPEG 4.

The NPU is a neural-network (neural-network, NN) computing processor, quickly processes input information by referring to a biological neural network structure, for example, by referring to a transfer mode between human brain neurons, and may further continuously perform self-learning. Applications such as intelligent cognition of the electronic device 100 may be implemented by using the NPU, for example, image recognition, facial recognition, speech recognition, and text understanding.

The external memory interface 120 may be used to connect to an external storage card, for example, a micro SD card, to extend a storage capability of the electronic device 100. The external memory card communicates with the processor 110 through the external memory interface 120, to implement a data storage function. For example, files such as music and videos can be saved on the external memory card, or transfer files such as music and video from an electronic device to an external memory card.

The internal memory 121 may be configured to store computer-executable program code. The executable program code includes instructions. The internal memory 121 may include a program storage area and a data storage area. The program storage area may store an operating system, an application required by at least one function (for example, a sound playing function or an image playing function), and the like. The data storage area may store data (such as audio data and a phone book) created in a process of using the electronic device 100. In addition, the internal memory 121 may include a high-speed random access memory, or may include a nonvolatile memory, for example, at least one magnetic disk storage device, a flash memory, or a universal flash storage (universal flash storage, UFS). The processor 110 executes various functional methods and data processing of the electronic device 100 by running the instructions stored in the internal memory 121 and/or the instructions stored in the memory disposed in the processor.

The electronic device 100 may implement an audio function, for example, music playing and recording, through the audio module 170, the speaker 170A, the receiver 170B, the microphone 170C, the headset jack 170D, the application processor, for example, music playing, recording, and the like.

The audio module 170 is configured to convert digital audio information into an analog audio signal for output, and is also configured to convert analog audio input into a digital audio signal. The audio module 170 may be further configured to encode and decode an audio signal. In some embodiments, the audio module 170 may be disposed in the processor 110, or some functional modules in the audio module 170 are disposed in the processor 110.

The speaker 170A, also referred to as a "loudspeaker", is configured to convert an audio electrical signal into a sound signal. The electronic device 100 may listen to music by using the speaker 170A, or output an audio signal of a hands-free call.

The receiver 170B, also referred to as an "earpiece", is configured to convert an audio electrical signal into a sound signal. When a call is answered or speech information is received through the electronic device 100, the receiver 170B may be put close to a human ear to listen to a voice.

The microphone 170C, also referred to as a "mike" or a "microphone", is configured to convert a sound signal into an electrical signal. When making a call or sending voice information, a user may make a sound near the microphone 170C through the mouth of the user, to input a sound signal to the microphone 170C. At least one microphone 170C may be disposed in the electronic device 100. In some other embodiments, two microphones 170C may be disposed in the electronic device 100, to collect a sound signal and implement a noise reduction function. In some other embodiments, three, four, or more microphones 170C may alternatively be disposed in the electronic device 100, to collect a sound signal, implement noise reduction, and identify a sound source, to implement a directional recording function and the like.

The headset jack 170D is used to connect a wired headset. The headset jack 170D may be a USB connector 130, or may be a 3.5 mm open mobile terminal platform (open mobile terminal platform, OMTP) standard interface, or a cellular telecommunications industry association of the USA (cellular telecommunications industry association of the USA, CTIA) standard interface.

The pressure sensor 180A is configured to sense a pressure signal, and can convert the pressure signal into an electrical signal. In some embodiments, the pressure sensor 180A may be disposed on the display 194. There are a plurality of types of pressure sensors 180A, such as a resistive pressure sensor, an inductive pressure sensor, and a capacitive pressure sensor. The capacitive pressure sensor may include at least two parallel plates made of conductive materials. When a force is applied to the pressure sensor 180A, capacitance between electrodes changes. The electronic device 100 determines pressure intensity based on the change in the capacitance. When a touch operation is performed on the display 194, the electronic device 100 detects intensity of the touch operation through the pressure sensor 180A. The electronic device 100 may also calculate a touch location based on a detection signal of the pressure sensor 180A. In some embodiments, touch operations that are performed in a same touch position but have different touch operation intensity may correspond to different operation instructions. For example, when a touch operation whose touch operation intensity is less than a first pressure threshold is performed on an SMS message application icon, an instruction for viewing an SMS message is performed. When a touch operation whose touch operation intensity is greater than or equal to the first pressure threshold is performed on the SMS message application icon, an instruction for creating a new SMS message is performed.

The gyroscope sensor 180B may be configured to determine a motion posture of the electronic device 100. In some embodiments, an angular velocity of the electronic device 100 around three axes (namely, axes x, y, and z) may be determined through the gyroscope sensor 180B. The gyroscope sensor 180B may be configured to implement image stabilization during shooting. For example, when a shutter is pressed, the gyroscope sensor 180B detects an angle at which the electronic device 100 jitters, obtains, through calculation based on the angle, a distance for which a lens module needs to compensate, and controls reverse motion of the lens to cancel the jitter of the electronic device 100, to implement image stabilization. The gyroscope sensor 180B may be further used in navigation and somatic game scenarios.

The barometric pressure sensor 180C is used to measure barometric pressure. In some embodiments, the electronic device 100 calculates an altitude based on a value of the barometric pressure measured by the barometric pressure sensor 180C, to assist in positioning and navigation.

The magnetic sensor 180D includes a Hall sensor. The electronic device 100 may detect opening and closing of a flip cover by using the magnetic sensor 180D. When the electronic device is a foldable electronic device, the magnetic sensor 180D may be configured to detect folding or unfolding, or a folding angle of the electronic device. In some embodiments, when the electronic device 100 is a clamshell phone, the electronic device 100 may detect opening and closing of a flip cover based on the magnetic sensor 180D, and further set, based on a detected opening or closing state of the flip cover, a feature such as automatic unlocking of the flip cover.

The acceleration sensor 180E may detect accelerations in various directions (usually on three axes) of the electronic device 100. When the electronic device 100 is still, a magnitude and a direction of gravity may be detected. The acceleration sensor 180E may be further configured to identify a posture of the electronic device, and is used in an application like switching between a landscape mode and a portrait mode or a pedometer.

The distance sensor 180F is configured to measure a distance. The electronic device 100 may measure a distance in an infrared manner or a laser manner. In some embodiments, in an image shooting scenario, the electronic device 100 may measure a distance by using the distance sensor 180F to implement quick focusing.

The optical proximity sensor 180G may include, for example, a light-emitting diode (LED) and a light detector, like a photodiode. The light-emitting diode may be an infrared light-emitting diode. The electronic device 100 emits infrared light outwards by using the light-emitting diode. The electronic device 100 detects infrared reflected light from a nearby object by using the photodiode. When intensity of detected reflected light is greater than a threshold, it may be determined that there is an object near the electronic device 100. When intensity of detected reflected light is less than a threshold, the electronic device 100 may determine that there is no object near the electronic device 100. The electronic device 100 may detect, by using the optical proximity sensor 180G, that the user holds the electronic device 100 close to an ear for a call, to automatically turn off a screen for power saving. The optical proximity sensor 180G may also be used in a smart cover mode or a pocket mode to automatically perform screen unlocking or locking.

The ambient light sensor 180L may be configured to sense ambient light brightness. The electronic device 100 may adaptively adjust brightness of the display 194 based on the sensed ambient light brightness. The ambient light sensor 180L may also be configured to automatically adjust white balance during image shooting. The ambient light sensor 180L may also cooperate with the optical proximity sensor 180G to detect whether the electronic device 100 is blocked. For example, the electronic device is in a pocket. When it is detected that the electronic device is blocked or is in a pocket, some functions (for example, a touch function) may be disabled, to prevent a misoperation.

The fingerprint sensor 180H may be configured to collect a fingerprint. The electronic device 100 may implement fingerprint-based unlocking, application lock access, fingerprint-based photographing, fingerprint-based call answering, and the like by using a feature of the collected fingerprint.

The temperature sensor 180J is configured to detect temperature. In some embodiments, the electronic device 100 executes a temperature processing policy based on temperature detected by the temperature sensor 180J. For example, when the temperature detected by the temperature sensor 180J exceeds a threshold, the electronic device 100 lowers performance of a processor, to reduce power consumption of the electronic device to implement thermal protection. In some other embodiments, when the temperature detected by the temperature sensor 180J is less than another threshold, the electronic device 100 heats the battery 142. In some other embodiments, when the temperature is less than still another threshold, the electronic device 100 may boost an output voltage of the battery 142.

The touch sensor 180K is also referred to as a "touch component". The touch sensor 180K may be disposed on the display 194, and the touch sensor 180K and the display 194 form a touchscreen, which is also referred to as a "touch control screen". The touch sensor 180K is configured to detect a touch operation performed on or near the touch sensor. The touch sensor may transfer the detected touch operation to the application processor to determine a type of the touch event. A visual output related to the touch operation may be provided through the display 194. In some other embodiments, the touch sensor 180K may also be disposed on a surface of the electronic device 100 at a location different from that of the display 194.

The bone conduction sensor 180M may obtain a vibration signal. In some embodiments, the bone conduction sensor 180M may obtain a vibration signal of a vibration bone of a human vocal-cord part. The bone conduction sensor 180M may also be in contact with a body pulse to receive a blood pressure beating signal. In some embodiments, the bone conduction sensor 180M may also be disposed in the headset, to obtain a bone conduction headset. The audio module 170 may parse out a voice signal based on the vibration signal that is of the vibration bone of the vocal-cord part and that is obtained by the bone conduction sensor 180M, to implement a voice function. The application processor may parse heart rate information based on the blood pressure beating signal obtained by the bone conduction sensor 180M, to implement a heart rate detection function.

The button 190 may include a power button, a volume button, and the like. The button 190 may be a mechanical button, or may be a touch button. The electronic device 100 may receive a key input, and generate a key signal input related to a user setting and function control of the electronic device 100.

The motor 191 may generate a vibration prompt. The motor 191 may be used for an incoming call vibration prompt and a touch vibration feedback. For example, touch operations performed on different applications (such as photographing and audio playing) may correspond to different vibration feedback effects. The motor 191 may also correspond to different vibration feedback effects for touch operations performed on different areas of the display 194. Different application scenarios (for example, a time reminder, information receiving, an alarm clock, a game) may also correspond to different vibration feedback effects. The touch vibration feedback effect can also be customized.

The indicator 192 may be an indicator light, and may be configured to indicate a charging status and a power change, or may be configured to indicate a message, a missed call, a notification, and the like.

The SIM card interface 195 is configured to connect to a SIM card. The SIM card may be inserted into the SIM card interface 195 or removed from the SIM card interface 195, so as to implement contact and separation from the electronic device 100. The electronic device 100 may support one or more SIM card interfaces. The SIM card interface 195 may support a nano-SIM card, a micro-SIM card, a SIM card, and the like. A plurality of cards may be inserted into the same SIM card interface 195 at the same time. Types of the plurality of cards may be the same or different. The SIM card interface 195 may also be compatible with different types of SIM cards. The SIM card interface 195 may also be compatible with an external memory card. The electronic device 100 interacts with a network through the SIM card, to implement functions such as calling and data communication. In some embodiments, the electronic device 100 uses an eSIM, that is, an embedded SIM card. The eSIM card may be embedded in the electronic device 100, and cannot be separated from the electronic device 100.

FIG. 2 schematically shows an electronic device 100 for performing an electrical connection by using an elastic conductive connection component according to an embodiment of this application. The electronic device 100 may include a first element 10, an elastic conductive connection component A, and a second element 20. The elastic conductive connection component A is disposed between the first element 10 and the second element 20, and the first element 10 and the second element 20 are electrically connected through the elastic conductive connection component A. Specifically, the elastic conductive connection component A has a first surface and a second surface that are disposed opposite to each other along a first direction (for example, a height direction), the first surface is electrically connected to the first element, and the second surface is electrically connected to the second element. In some embodiments, the first element 10 may be a middle frame of the electronic device, and the middle frame is grounded.

In some embodiments, the second element 20 may be a display assembly, the first element 10 is the middle frame of the electronic device, and the display assembly may be connected to the middle frame through the elastic conductive connection component A, to implement grounding. Specifically, the middle frame is electrically connected to the first surface of the elastic conductive connection component A, and the display assembly is electrically connected to the second surface of the elastic conductive connection component A.

In some other embodiments, the second element 20 may be a shielding cover, the first element 10 may be the middle frame of the electronic device, and the second element 20 and the first element 10 are electrically connected through the elastic conductive connection component A, to implement grounding of the shielding cover. It should be understood that the shielding cover may be configured to implement grounding of an outer surface of a component (for example, a radio frequency front-end module) disposed inside the electronic device.

In some other embodiments, the second element 20 is a camera module, the second element 10 is the middle frame of the electronic device, and the camera module is electrically connected to the middle frame through the elastic conductive connection component A, to implement grounding of the camera module.

In some other embodiments, the second element 20 is an antenna part, the second element 10 is the middle frame of the electronic device, and the antenna part is electrically connected to the middle frame through the elastic conductive connection component A, to implement grounding.

In some embodiments, the elastic conductive connection component A may be further configured to implement grounding of a PCB (Printed Circuit Board, printed circuit board), a cable, or the like.

FIG. 3A is a schematic cross-sectional view of an elastic conductive connection component A. It should be understood that the elastic conductive connection component A is a three-dimensional structure having a length, a width, and a height. In some embodiments, the elastic conductive connection component A may be conductive gaskets (for example, FOF (Fabric over Foam, conductive fabric over gaskets), conductive gaskets, perforated gaskets, or fabric over gaskets). In a schematic structure of the elastic conductive connection component shown in FIG. 3A, the elastic conductive connection component includes a first surface (a surface connected to the first element 10) and a second surface (a surface connected to the second element 20) that are disposed opposite to each other in a first direction (for example, a height direction H), two side faces (for example, a left side face and a right side face, where the left side face and the right side face are not shown in the figure) opposite to each other in a second direction (for example, a width direction W), and two side faces (not shown in the figure) that are disposed opposite to each other in a third direction (for example, a length direction L, where the length direction L is perpendicular to the width direction W and perpendicular to a paper direction). In some embodiments, shapes of the first surface and the second surface may be rectangular, circular, elliptic, trapezoidal, or the like. It should be understood that shapes of the first surface and the second surface may be different. In other words, a contact surface of the elastic conductive connection component A connected to the first element may be different from a contact surface of the elastic conductive connection component A connected to the second element. For example, the conductive gaskets are used to connect a display to a middle frame to implement grounding, and a contact area of the first surface connected to the display and a spring plate may be less than a contact area of the second surface connected to the middle frame and the spring plate.

The elastic conductive connection component shown in FIG. 3A has elasticity, and an initial height of the elastic conductive connection component is h0. The elastic conductive connection component changes a height after being compressed, where the changed height is a deformation amount. For example, a deformation amount of the elastic conductive connection component after being compressed may be h1. If being further compressed, the deformation amount of the elastic conductive connection component may reach h3, where h3 is greater than h1.

In this implementation, both shapes of a cross section of a first plane (for example, a cross section cut along a plane HW, where the plane HW is a plane formed by the height direction H and the width direction W) and a cross section of a second plane (for example, a cross section cut along a plane HL, where the plane HL is a plane formed by the height direction H and the length direction L) of the elastic conductive connection component are rectangular. A person skilled in the art may understand that, in another alternative implementation, shapes of the cross section of the first plane and the cross section of the second plane of the elastic conductive connection component may also be other shapes, for example, trapezoidal, which may be specifically and properly set according to an actual usage environment and use requirements. The protection scope of this application is not limited herein. It should be further understood that, when the elastic conductive connection component is the spring plate, a cross section cut along the width W direction (or the length L direction) of the elastic conductive connection component may be formed by an outline of the spring plate.

FIG. 3B is another schematic cross-sectional view of an elastic conductive connection component A. It should be understood that the elastic conductive connection component A is a three-dimensional structure having a length, a width, and a height. In some embodiments, the elastic conductive connection component A may be a spring plate.

Related descriptions in FIG. 3A may be cited for descriptions of changing a height of the spring plate under a force. Details are not described herein again.

Advantages and disadvantages of a grounding solution of the elastic conductive connection component A can be measured by a DFR (Deformation, Force, Resistance, deformation amount, a force, resistance) curve. As shown in FIG. 3A, a horizontal coordinate in the figure is a deformation amount (Deformation), and a vertical coordinate is ground resistance (Resistance) and a force (Force).

In FIG. 3C, a curve a is a curve of a relationship between the ground resistance and the deformation amount of the elastic conductive connection component A when the elastic conductive connection component A is connected to the first element and the second element, where the first element is electrically connected to a reference ground. The ground resistance of the elastic conductive connection component A decreases with the increase of the deformation amount. To meet a requirement that the ground resistance needs to be less than maximum ground resistance, a first region in which the ground resistance is lower than upper resistance is a workable region in which the resistance meets the requirement, that is, the deformation amount of the elastic conductive connection component A needs to be in the first region (for example, the deformation amount is between h1 and h2 as shown in FIG. 3A), to meet the requirement of ground resistance. Therefore, the deformation amount of the elastic conductive connection component A needs to reach a minimum deformation amount, and a deformation amount greater than the minimum deformation amount is a compression range that meets the grounding requirement. It should be understood that h2 in FIG. 3A may be infinitely close to a thickness of the elastic conductive connection component A. In some embodiments, upper limit ground resistance is 0.2 ohms, and ground resistance less than 0.2 ohms is referred to as low resistance.

Curves (curves a) of a relationship between ground resistance and a deformation amount corresponding to different elastic conductive connection components A are different. For example, with the increase of the deformation amount, a rate at which ground resistance of a first elastic conductive connection component A decreases with the increase of the deformation amount may be greater than that of a first connecting piece B. In this case, to reduce the ground resistance to the upper limit resistance, a smallest deformation amount required by the first elastic conductive connection component A is less than a smallest deformation amount required by a second elastic conductive connection component A. Therefore, it may be considered that a compression range of the first elastic conductive connection component A that meets the resistance requirement is larger. For example, heights of both the first elastic conductive connection component A and the second elastic conductive connection component A are 1.5 mm. The first elastic conductive connection component meets the ground resistance requirement when the deformation amount is 0.2 mm, and the second elastic conductive connection component A needs to meet the ground resistance requirement when the deformation amount is 0.5 mm. Therefore, a compression range in which the first elastic conductive connection component A meets the resistance requirement is 0.2 mm to 1.5 mm, and a compression range in which the second elastic conductive connection component A meets the resistance requirement is 0.5 mm to 1.5 mm. Therefore, the compression range in which the first elastic conductive connection component A meets the resistance requirement is wider.

A curve b is a curve of a relationship between a force (or a force applied to a first element 10 and/or a second element 20) and a deformation amount of the elastic conductive connection component A when the elastic conductive connection component A is connected to the first element and the second element. It can be learned that the force on the elastic conductive connection component A increases with the increase of the deformation amount. It should be understood that the force needs to be between a lower limit force and an upper limit force to meet a force requirement. The lower limit force is a force value of the elastic conductive connection component A when the elastic conductive connection component A is in a corresponding deformation amount that meets the resistance requirement. The upper limit force is set to ensure that the first element and/or the second element are/is not damaged by an excessive force. For example, in an application scenario in which a display is grounded, because the force is too large, the force causes a flexible display to generate a film print, and this affects beauty of the display.

In some embodiments, it is required that a grounding force is not greater than 0.5 N, or for a common elastic conductive connection component, an area of a contact surface (a first surface and a second surface) with the first element and/or the second element is 2.5 mm*2.5 mm. Pressure intensity generated by the elastic conductive connection component at the maximum deformation amount is not greater than 0.08 Mpa. It should be understood that, for different grounding scenarios, required upper limit forces may be different.

A compression range region in which the elastic conductive connection component A meets a force requirement is a second region. A force generated by the elastic conductive connection component A needs to be greater than a minimum force value (a force value corresponding to the upper resistance) and less than a maximum force value. In other words, to meet the force requirement, the deformation amount of the elastic conductive connection component A is within a range (for example, between h1 and h3, where h1 is a deformation amount that meets a maximum ground resistance requirement and h3 is a deformation amount corresponding to the upper limit force value). It should be understood that, for different elastic conductive connection components A, the upper limit force value and/or the lower limit force value are different.

A region in which the compression range of the elastic conductive connection component A meets both resistance and force requirements is a third region. An interval in which a deformation amount of a first region and a deformation amount of the second region overlap is a compression range of the third region (for example, as shown in FIG. 3, a compression range of the first region is h1 to h2, and a compression range of the second region is h1 to h3, where h3 is less than h2, and then a compression range of the third region is h1 to h3). It should be noted that, in this embodiment of this application, a compression range of the elastic conductive connection component corresponding to the third region that meets resistance and a force requirement is defined as a working range of the elastic conductive connection component.

A wider compression range of the third region corresponding to the elastic conductive connection component A indicates a larger working range of the elastic conductive connection component A that meets both resistance and force requirements. It may be considered that a wider application scenario of the elastic conductive connection component A indicates a better grounding solution.

Generally, when a grounding connection is implemented through the elastic conductive connection component A, a resistance requirement needs to be met, that is, the ground resistance is not greater than the maximum ground resistance. In addition, as a structure of an electronic device becomes more complex and light, functions of the electronic device are diversified, and forms are diversified, the grounding solution further needs to meet a force requirement that a force is not greater than maximum upper limit force in addition to the resistance requirement. For example, in a scenario in which a display assembly is grounded, an upper limit force value that can be borne by the display assembly is 5 N. Therefore, a force generated by the elastic conductive connection component A needs to be less than 5 N. Otherwise, the display assembly is damaged. In addition, in some scenarios, for example, in a scenario in which a high-resolution camera is grounded, the elastic conductive connection component A not only needs to meet a grounding requirement of low resistance and a low force, but also needs to meet a grounding requirement with a low frequency spurious, to avoid frequency spurious noise affecting normal operation of the camera.

As shown in FIG. 4, an electronic device may use a spring plate 30 to electrically connect a first element 10 to a second element 20. In some embodiments, the first element 10 is a middle frame, the second element 20 is at least one component or module of a display, a camera module, an antenna, or a shielding cover, and the spring plate is connected to the middle frame and the second element 20, to implement grounding of the second element 20.

To resolve a problem of spring plate yield, the spring plate is usually made of high elastic modulus metal. A force on high elastic modulus elasticity increases sharply with an increase of a deformation amount. As a result, a compression range of the spring plate corresponding to the second region that meets a force requirement is very small, and a corresponding compression range in the third region is reduced, that is, a working range of the spring plate is limited. In other words, a curve b corresponding to the spring plate is steeper, and a compressible range of the spring plate is smaller.

In addition, in a use process of the spring plate, the force increases sharply with the deformation amount, easily exceeds an upper limit of structure bearing of the spring plate, resulting in failure of the spring plate. In addition, if the spring plate is used to connect the middle frame to the display assembly to implement grounding of the display assembly, because force generated by the spring plate increases sharply, a film print is easily generated in the display assembly.

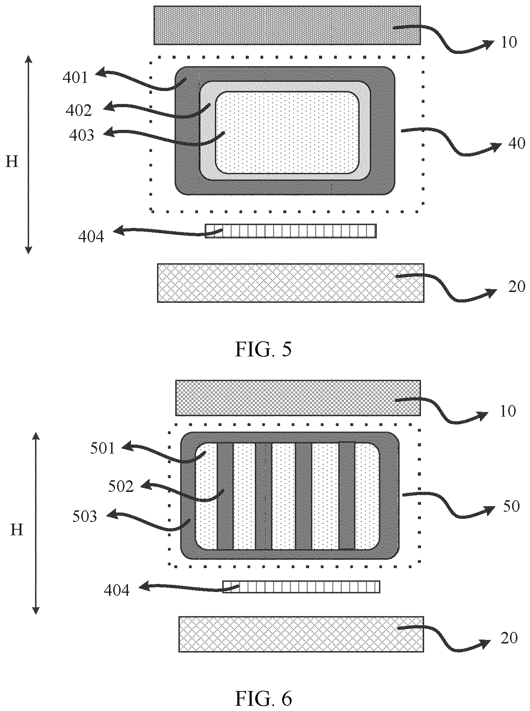

As shown in FIG. 5, the electronic device may alternatively use FOF gaskets 40 to connect the first element 10 and the second element 20. The FOF gaskets have a first surface and a second surface that are disposed opposite to each other in a height H direction, where the first surface is electrically connected to the first element 10 and the second surface is electrically connected to the second element 20. It should be understood that the FOF gaskets include at least a foam 403, a hot melt adhesive layer 402 covering a surface of the foam, and a conducting wrapping layer 401 covering the surface of the hot melt adhesive layer. The wrapping layer 401 may be a conductive fabric. It should be understood that a conductive adhesive 404 may be added between the FOF gaskets and the first element 10 and/or the second element, to bond the FOF gaskets and the first element 10 and/or the second element. It should be understood that, due to a process limitation, a minimum size of the wrapping layer 401 can only be at a micrometer level.

The FOF gaskets are characterized by a choice of foams with different densities to meet a requirement of a low rebound force. Conduction between the first surface and the second surface of the FOF gaskets is implemented by pressing tightly the wrapping layer by using a rebound force of the foam 403 and the first element 10 (or the second element 20). If a resistance requirement needs to be met, the FOF gaskets require a larger deformation amount. As a result, a compression range in which the FOF gaskets meet a ground resistance requirement in FIG. 3C is limited, and a compression range of the foam is small. In addition, because the FOF gaskets have the conducting wrapping layer 401 and the hot melt adhesive layer 402 that are incompressible, in other words, excessive force causes the conducting wrapping layer 401 and the hot melt adhesive layer 402 to break, causing the FOF gaskets to fail. Therefore, a compressible rebound range of the FOF gaskets to meet the force requirement in FIG. 3C is limited and the compression range is narrow. Because a compression range that meets the grounding requirement and the force requirement is limited, a compression range of the foam corresponding to the third region becomes smaller, that is, a workable range is reduced. For example, a height of the FOF gaskets is 1 mm, a compression range of the FOF gaskets to meet the resistance requirement and the force requirement is 0.7 mm to 0.75 mm, and a working range of the FOF gaskets is about 0.25 mm to 0.3 mm. After the deformation amount is greater than 0.75 mm, due to existence of the conducting wrapping layer 401 and the hot melt adhesive layer 402 with limited compression, the FOF gaskets cannot achieve a working height lower than 0.25 mm. In addition, the FOF gaskets are easily pressed and broken, resulting in an increase in resistance.

As shown in FIG. 6, the electronic device may alternatively use perforated gaskets 50 to connect the first element 10 and the second element 20. The perforated gaskets 50 include a foam 501, and a metallization wrapping layer 503 that covers around the foam 501. A first surface (a surface electrically connected to the first element 10) and a second surface (a surface electrically connected to the second element 20) that are disposed opposite to each other in a height H direction are conducted through a conducting through hole (or a metal rod) 502. The conducting through hole may be formed through electroplating or electroless plating, and an electrical connection between the first surface and the second surface is implemented through the conducting through hole.

However, when the perforated gaskets are under a force, a metal layer formed through electroplating or electroless plating in the conducting through hole is easily broken, resulting in unstable ground resistance, which limits a compression range corresponding to the perforated gaskets in the first region shown in the curve in FIG. 3B. As a result, a compression range corresponding to the third region is reduced, that is, a working range of the perforated gaskets is narrow. It should be understood that, due to a process limitation, a minimum size of the metallization wrapping layer 503 and a metal layer in the through hole 502 can only be at a micrometer level.

In addition, after metal in the through hole 502 is pressed and broken, a high frequency spurious may increase, and electromagnetic interference may be easily generated on a component module (for example, a display or a camera module).

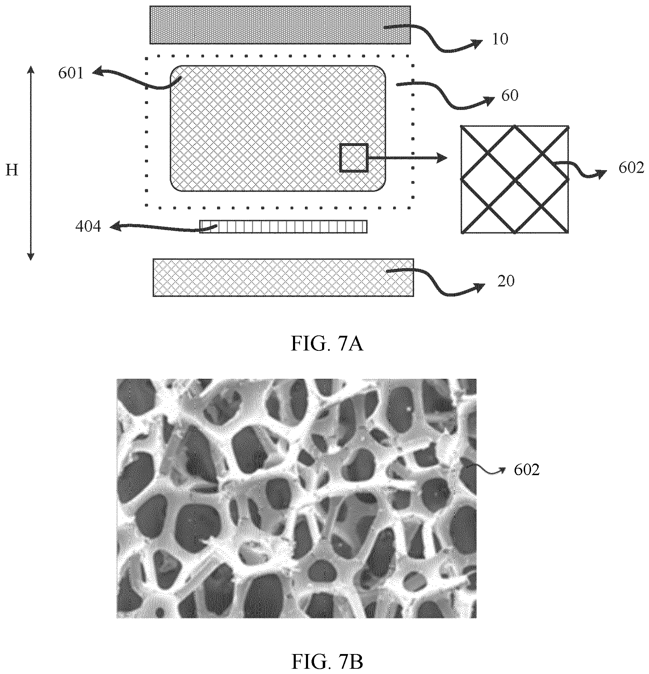

As shown in FIG. 7A and FIG. 7B, the electronic device may alternatively use fabric over gaskets 60 to connect the first element 10 and the second element 20. The fabric over gaskets are made of a metallization foam 601. In a process, similar to the perforated gaskets 50, the foam of the foam may be metalized through electroless plating or electroplating to achieve conductivity. It should be understood that an internal structure of the foam is a mesh line structure 602, and the mesh line is a region on which electroplating or electroless plating is performed. The electroplating can increase conductivity of the mesh line, metallize the foam, and increase the conductivity of the foam. An electrical connection between the first element 10 and the second element 20 can be achieved by using the foam with conductivity. It should be understood that the foam is a three-dimensional structure. FIG. 7A shows only a schematic mesh connection of a two-dimensional plane, and a mesh shape is schematic. FIG. 7B shows a partial view of the metallization foam 601 under an electron microscope. It can be learned that the metallization foam 601 is a three-dimensional mesh structure, and nodes in the mesh are connected through wires, and the wires implement a conducting effect by using an electroplating process. It should be understood that, due to a limitation of an electroplating or electroless plating process, a minimum size of a metal plating layer on the mesh line structure 602 can only be at a micrometer level.

Similar to the perforated gaskets 50, after the fabric over gaskets 60 are compressed, a rebound property of the foam is damaged by a conductive process (for example, electroplating) applied to the foam 601, and the metal plating layer in the metallization foam 601 is prone to break and fall off. The metallization foam 601 is prone to break, and this limits a compression range of a third region of the fabric over gaskets (for example, the third region shown in FIG. 3A), that is, a working range of the fabric over gaskets is narrow.

In addition, after the metal plating layer in the metallization foam 601 is broken, a high frequency spurious may increase, and this interferes with normal operation of another component or module (for example, a display assembly or a camera module).

As functions of the electronic device increase, components (or modules) in the electronic device increase continuously. Therefore, a grounding solution requires free grounding at a required position, and the elastic conductive connection component A needs to have a wider compression range or a larger working range, to implement electrical connections between different components or ground different components.

However, in an existing grounding solution, a corresponding working range of the elastic conductive connection component that meets both a resistance requirement and a force requirement is too narrow, and the elastic conductive connection component easily generates a high frequency spurious, and cannot implement effective grounding. The high frequency spurious causes electromagnetic interference to normal display of the display assembly. It should be understood that the frequency spurious may be measured through PIM (Passive Intermodulation, passive intermodulation), and a unit is dBm. Generally, a grounded PIM value is required to be less than -80 dBm.

Therefore, to achieve free grounding in a plurality of scenarios, the elastic conductive connection component needs to have a wide working range (for example, a wide compressible range that meets both resistance and force requirements), and needs to meet a low frequency spurious operating requirement at the same time. For example, in a scenario in which the display assembly is grounded, a working range of the elastic conductive connection component is required to be a first compression range. In a scenario in which the camera module is grounded, a working range of the elastic conductive connection component is required to be a second compression range. In a scenario in which an antenna part is grounded, a working range of the elastic conductive connection component is required to be a third compression range. Currently, working ranges of a spring plate, FOF (Fabric over Foam, conductive fabric cover gaskets) gaskets, perforated gaskets, and fabric over gaskets cannot include the first compression range, the second compression range, and the third compression range, and grounding in a plurality of application scenarios cannot be implemented.

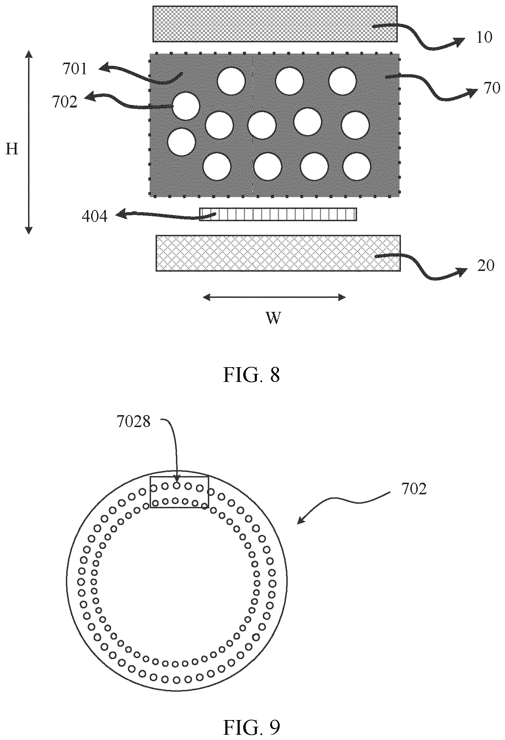

An embodiment of this application provides an elastic conductive connection component. Refer to FIG. 8 and FIG. 9. The elastic conductive connection component has an internal opening hole 702, and a nanowire 7021 is attached to the internal opening hole 702. The elastic conductive connection component can meet a resistance requirement and a force requirement in a wide working range. In addition, because the elastic conductive connection component uses the nanowire as a conducting layer, the nanowire is not prone to fall off and break, and therefore has an advantage of a low frequency spurious.

The elastic conductive connection component provided in this embodiment of this application is used on an electronic device. Because the elastic conductive connection component has a wide working range, the elastic conductive connection component may be applied to a plurality of application scenarios, a free connection between components of the electronic device or free grounding of components of the electronic device is implemented. For example, the elastic conductive connection component may be applied to grounding of a display assembly, may be applied to grounding of a camera module, or may be applied to grounding of an antenna part. In addition, because the elastic conductive connection component is featured as a low frequency spurious, the electronic device using the elastic conductive connection component can avoid electromagnetic interference between components or modules, and reduce an ESD phenomenon. The elastic conductive connection component can be used for free grounding of a terminal device, a vehicle-mounted device, and the like.

FIG. 8 shows a schematic cross-sectional view of an elastic conductive connection component 70 provided in an embodiment of this application along an HW plane (a plane formed in a height H direction and a width W direction). The elastic conductive connection component 70 includes a foam 701. A plurality of inner holes 702 are opened inside the foam 701, and a nanowire is attached to a hole wall of the inner hole 702.

Cross-sectional shapes of the foam 701 on different planes (for example, along a first plane (the plane formed in the height H direction and the width W direction), along a second plane (a plane formed in the height H direction and a length L direction), and along a third direction (a plane formed in the length L direction and the width W direction)) may be referenced from the foregoing related description of a cross section of the elastic conductive connection component in FIG. 3B. Details are not described herein again.

The elastic conductive connection component 70 is electrically connected to a first element 10 through a first surface, and is electrically connected to a second element 20 through a second surface, where the first surface and the second surface are disposed opposite to each other in the height H direction.

In some embodiments, a conductive adhesive 404 may be included between the elastic conductive connection component A and the second element 20. In some embodiments, a conductive adhesive (not shown) may also be included between the elastic conductive connection component A and the first element 10. Optionally, the conductive adhesive may be a force-sensitive adhesive. Optionally, the conductive adhesive is doped with a conductive particle, and the conductive particle is one or a combination of gold, silver, copper, aluminum, zinc, iron, and nickel. Optionally, the conductive adhesive may alternatively be attached to a nanowire, and the nanowire may be one or a combination of gold, silver, copper, aluminum, zinc, iron, and nickel.

The conductive adhesive is used, so that while the elastic conductive connection component A is electrically connected to the first element and/or the second element, the conductive adhesive can relieve force, and can be firmly bonded to prevent falling off. By doping nano-conductive particles in the conductive adhesive, the conductive adhesive can be viscous, and ground resistance can be reduced.

In some embodiments, a material of the foam 701 may be at least one material of PU (poly urethane, polyurethane), PP (polypropylene, polypropylene), PE (polyethylene, polyethylene), PI (Polyimide, polyimide), silica gel, polypropylene (polypropylene, PP), styrene-butadiene rubber, acrylate, vinyl acetate, vinylidene chloride, nitrile, silicone, acrylamide, natural rubber, polyvinyl chloride, polysulfide rubber, styrene-acrylate copolymer, vinyl acetate, acrylate copolymer, silicone-acrylate copolymer and modified silicone-acrylate copolymer, and rubber.

The foam 701 is provided with the inner hole 702, where the inner hole 702 may be formed through foaming. It should be understood that the inner hole is merely a schematic name, and does not represent a limitation on a size, a position, a shape, or the like of a hole opened on the foam 701.

Because the foam 701 is provided with the inner hole 702, a density of the foam 701 can be reduced, and a rebound force generated by the foam slowly increases after the foam is compressed. In this way, a working range of the foam can be increased. Compressible space and the working range of the foam are larger than those of the foam (for example, the FOF gaskets, the perforated gaskets, or the fabric over gaskets) in a conventional technology, and can be more than twice as large.

In some embodiments, the density of the foam with the inner hole may be less than 200 kg/m². It should be understood that, in this embodiment of this application, a density less than 200 kg/m² is referred to as a low density. Because the elastic conductive connection component provided in the embodiments of FIG. 8 and FIG. 9 uses a foam with an inner hole, and a force (or a rebound force) generated after the foam is compressed increases slowly, so that a deformation amount corresponding to upper limit force of the foam can be ensured to be larger, so as to expand a compressible range of the foam to meet a force requirement (for example, a compression range of a second region in FIG. 3B) and broaden the working range of the elastic conductive connection component. For example, in FIG. 3B, a slope of a curve b (the force changes with the deformation amount) of the elastic conductive connection component provided in this embodiment of this application is small, and the force changes slowly with the increase of the deformation amount. Before the force reaches the upper limit force, a compression range corresponding to the second region is larger, and a workable range of the elastic conductive connection component is larger. In other words, for example, an initial height of the conventional elastic conductive connection component without force is 1 mm, and a height that meets the force and resistance requirements can only vary between 0.25 mm and 0.3 mm. However, the elastic conductive connection component provided in this embodiment of this application may vary between 0.25 mm and 0.8 mm. Corresponding to a DFR curve in FIG. 3B, the compressible range of the second region may reach more than twice that of the conventional elastic conductive connection component. For example, for a common conductive elastic connecting body, a height of the conductive elastic connecting body is 1.2 mm or 1.5 mm, an area of the first surface or the second surface is 2.5 mm*2.5 mm, compression of the foam reaches 70% to 75%, and pressure strength generated by compression of the foam is less than 0.08 MPa. In other words, a maximum deformation amount of the foam that meets the force requirement may reach 70% to 75%, a rebound force generated by the foam under force is less than 0.5 N, and is still less than the upper limit force (as shown in FIG. 3B). The conductive elastic connecting body has a wide working range while meeting the force requirement.

In some embodiments, as shown in FIG. 8, inner holes 702 do not connect to each other, and all the inner holes 702 in the elastic conductive connection component 70 are closed and complete holes. The inner hole 702 contains gas to form a bubble, and the bubble is surrounded by hole walls, so that air and moisture cannot enter the inner hole 702. After the elastic conductive connection component 70 is compressed, the gas in the inner hole generates counteraction force, so that the elastic conductive connection component 70 can rebound. It should be noted that, in this embodiment of this application, inner holes that do not connect to each other in the foam are referred to as closed holes.

The elastic conductive connection component with closed holes inside has rigidity and stability and a good rebound capability.

A shape of the inner hole 702 may be spherical, elliptical, or the like. The shape of the inner hole 702 is not limited in this embodiment of this application. The shape of the inner hole 702 may be approximately spherical or approximately elliptical in view of an actual processing error. In some embodiments, the shape of the inner hole 702 may include both sphere and ellipse. In some embodiments, the shape of the inner hole 702 may alternatively be another shape. This is not limited in this embodiment of this application.

The shape of the inner hole 702 may be spherical, elliptical, or the like. When being compressed, the elastic conductive connection component may be compressed evenly. The force is released on a hole wall of an inner hole of the sphere or ellipse, so that damage caused by uneven force on the conductive elastic connecting body can be avoided, and at the same time, ground resistance can be kept stable.

In some embodiments, to obtain slowly increasing force (or a rebound force), and expand a compression range corresponding to the foam in the second region shown in FIG. 3A, a size of the inner hole 702 may be 20 um to 500 um, where the size may refer to a diameter of the inner hole 702, or may be a distance between two points on the hole wall of the inner hole that are furthest from each other. In some embodiments, to make the foam have a wide resilient working range, and can also have rigidity and stability, to avoid damage under force, an inner hole size of the foam may be 100 um.

In some embodiments, the inner hole 702 may alternatively be a cylindrical through hole that connects the first surface and the second surface (similar to the through hole 502 of the perforated gaskets in FIG. 6). The first surface and the second surface are two surfaces opposite to each other in a height H direction of the elastic conductive connection component. The elastic conductive connection component is electrically connected to a first element 10 through the first surface, and is electrically connected to a second element 20 through the second surface.

FIG. 9 is a schematic cross-sectional view of the inner hole 702 in FIG. 8 when the inner hole 702 is spherical. A conducting layer 7028 may be attached to a hole wall of the inner hole 702. The conducting layer 7028 is a nanowire, and the nanowire may include but is not limited to at least one of a carbon nanotube, a tin nanowire, a copper nanowire, a nickel nanowire, a silver nanowire, and a gold nanowire. The nanowire may be attached to the hole wall of the inner hole in a coating or drop coating manner. An example in which the nanowire is coated on the inner hole is used for schematic description in this embodiment of this application.

Because the nanowire is coated on the hole wall of the inner hole of the elastic conductive connection component provided in this embodiment of this application, a problem of deterioration of ground resistance caused by break of an electroplating layer on FOF gaskets and perforated gaskets can be avoided, and stable low resistance can be implemented in a large compression range. That is, a compression range corresponding to the first region in the DFR curve in FIG. 3C is larger. Because the nanowire is used as a conducting layer, strength of the nanowire and bonding force between the nanowire and the foam are higher than bonding force between the electroplating layer commonly used in the conventional technology and the foam. This resolves a problem in the conventional technology that the ground resistance is unstable caused by falling off of the electroplating layer of the fabric over gaskets and the perforated gaskets.

In some embodiments, a diameter of the nanowire coated on the hole wall is between 10 nm and 100 nm.

The diameter of the nanowire coated on the hole wall is controlled between 10 nm and 100 nm, so that the nanowire can be more firmly coated on the hole wall of the inner hole, and a high frequency spurious caused by the nanowire falling off under force is avoided. In addition, by setting the diameter in the range between 10 nm and 100 nm, low ground resistance can be obtained.

In some embodiments, a ratio of a length to the diameter of the nanowire ranges from 1000:1 to 5000: 1.

The ratio of the length to the diameter of the nanowire ranges from 1000:1 to 5000:1, which can avoid the fracture of the nanowire caused by the conductive elastic connecting body under force, so that the nanowire has rigidity and stability.

In some embodiments, the diameter of the nanowire is about 70 nm to enhance conductivity, prevent the nanowire from falling off due to force on the foam, and avoid generation of a high frequency spurious. It should be understood that, in an actual processing process, a ratio of a nanowire diameter and a length diameter of an actual product may be deviated, but only within an error tolerance range.

Therefore, the elastic conductive connection component in this embodiment of this application uses a foam that has an inner hole and the inner hole is coated with the nanowire. Because the inner hole is coated with the nanowire, ground resistance is remained in low resistance. When a deformation amount of the foam is only 5%, the resistance can be less than 0.2 ohms, which meets a ground resistance requirement. In addition, because there is an inner hole in the foam, when the elastic conductive connection component is compressed, the force (or the rebound force) slowly increases, and a compression range of the second region corresponding to an upper limit force is wide. Therefore, a compression range of the third region of the elastic conductive connection component is wide, that is, a working range of the elastic conductive connection component meeting both a resistance requirement and a force requirement is wide.

Because a uniform nanowire is formed on the hole wall of the inner hole of the foam as the conducting layer, the conducting layer has better stability than an electroplating layer formed by a conventional process. The conducting layer is not prone to break and fall off, and a high frequency spurious can be avoided.

The conductive elastomer in this embodiment of this application forms an elastic conductive connection component in a manner of compounding a nanowire and a foam, and a working range of the foam is wide. In addition, because the nanowire is used as a conducting layer, strength of the nanowire and bonding force between the nanowire and the foam are higher than bonding force between the electroplating layer commonly used and the foam. This resolves a problem of resistance instability and a high frequency spurious caused by falling off of the coating layer of the fabric over gaskets and the perforated gaskets in the conventional technology.

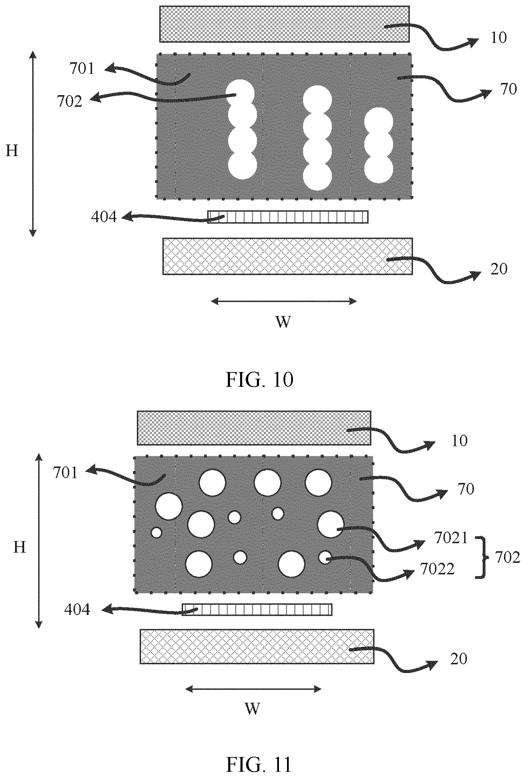

FIG. 10 shows another schematic cross-sectional view of an elastic conductive connection component 70 provided in an embodiment of this application along an HW plane (a plane formed in a height H direction and a width W direction). In some embodiments, the holes 702 may also connect to each other, as shown in FIG. 10. It should be noted that connecting holes are referred to as opening holes. The holes 702 constituting the opening holes connect to each other, so that gas can flow between the holes, which makes the elastic conductive connection component be a softer and more flexible material.

A difference between the conductive connecting body in the embodiment in FIG. 10 and the conductive connecting body in the embodiment in FIG. 8 lies in that, inner holes of the conductive connecting body in the embodiment in FIG. 10 connect to each other, and the inner holes are opening holes.

Related content in the embodiments in FIG. 8 and FIG. 9 may be cited for descriptions of shapes and sizes of the inner holes 702, coated nanowires, and corresponding beneficial effects. Details are not described herein again.

In some embodiments, the elastic conductive connection component may include both an opening hole and a closed hole (not shown in the figure), where the opening hole and the closed hole are coated with nanowires. The structure of the elastic conductive connection component includes both the opening hole and the closed hole, and may be rigid and stable, and a position or region of the opening hole may be adjusted, so that the elastic conductive connection component may also have a soft and flexible feature.

In some embodiments, the elastic conductive connection component includes both an opening hole region and a closed hole region, where the opening hole region and the closed hole region are located at different locations. For example, the closed hole region may be disposed on two sides along a width W direction, and the opening hole region is disposed between closed hole regions. By disposing closed hole regions on both sides partially along the width W direction, and disposing open-hole regions between the closed-hole regions along the width W direction, the two sides along the width W direction can be rigid and stable, and a connection of the connecting piece does not fall off. At the same time, the connecting piece has sufficient flexibility in a main connection region (for example, a middle region of a section of the elastic conductive connection component along the width W direction), to ensure that the elastic conductive connection component has a wide working range.

FIG. 11 shows another schematic cross-sectional view of an elastic conductive connection component 70 provided in an embodiment of this application along an HW plane (a plane formed in a height H direction and a width W direction).

Related content in the embodiments in FIG. 8 and FIG. 9 may be cited for descriptions of shapes and sizes of the inner holes 702, coated nanowires, and corresponding beneficial effects. Details are not described herein again.

A difference between the conductive connecting body in the embodiment in FIG. 11 and the conductive connecting body in the embodiment in FIG. 8 lies in that: an inner hole of the conductive connecting body in the embodiment in FIG. 11 includes at least two inner holes of different sizes. For example, the foam 701 includes an inner hole 7021 of a first size and an inner hole 7022 of a second size. It should be understood that the size may refer to a diameter of the hole. It should be noted that inner holes of different sizes may form opening holes (for example, the inner hole 7021 communicates with the inner hole 7022). The inner holes of different sizes may also be closed holes (for example, the inner hole 7021 and the inner hole 7022 do not connect to each other, the inner holes 7021 do not connect to each other, and the inner holes 7022 do not connect to each other). This is not limited in this embodiment of this application.

By opening the inner holes of different sizes in the foam, the connecting piece can be soft and flexible while ensuring good rigidity and stability.

In some embodiments, inner holes 7021 of the first size connect to each other to form an opening hole, and inner holes 7022 of the second size do not connect to each other to form a closed hole. By forming different structures (opening holes or closed holes) with different sizes of inner hole structures, the elastic conductive connection component can be rigid and stable, and can also be soft and prone to bend.

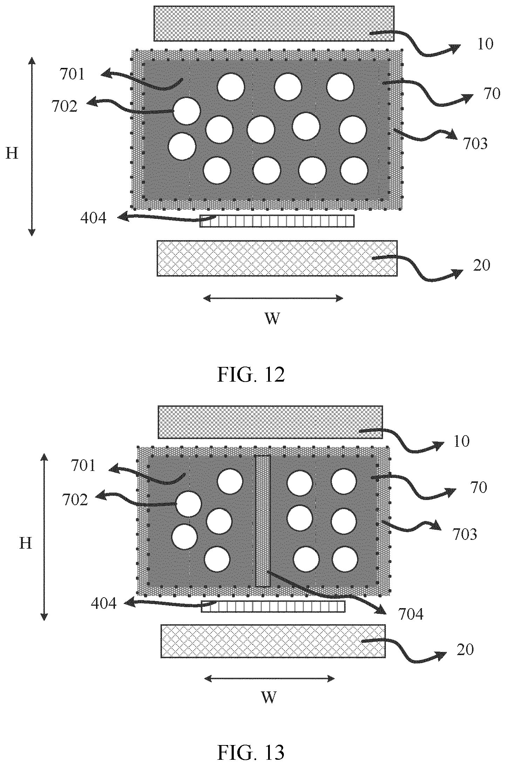

FIG. 12 shows another schematic cross-sectional view of an elastic conductive connection component 70 provided in an embodiment of this application along an HW plane (a plane formed in a height H direction and a width W direction).

A difference between the elastic conductive connection component shown in FIG. 12 and the elastic conductive connection component shown in FIG. 8 lies in that the foam surface of the elastic conductive connection component shown in FIG. 10 is covered with a metal conducting layer 703. It should be understood that, in this embodiment of this application, a covering process is different from a coating process, and a size of a covered metal layer is different from a size of a coated nanowire.

In some embodiments, a metal conducting layer 703 is a conductive fabric, and a material of the conductive fabric may be a nickel-plated fiber cloth, a gold-plated fiber cloth, a carbon-plated fiber cloth, or an aluminum foil fiber cloth. It should be understood that the conductive fabric is made of a fiber cloth (generally a polyester fiber cloth) as a base material, and a metal plating layer is electroplated to make the conductive fabric have a metal conductive characteristic. For example, the nickel-plated fiber cloth is plated with nickel on the polyester fiber cloth to make it conductive.

Related content in the embodiments in FIG. 8 and FIG. 9 may be cited for descriptions of shapes and sizes of the inner holes 702, coated nanowires, and corresponding beneficial effects. Details are not described herein again. In some embodiments, similar to the embodiment in FIG. 11, the inner hole in the embodiment in FIG. 12 may also have different sizes, or the inner hole includes both an opening hole and a closed hole, or positions of the opening hole and the closed hole are different. For descriptions of disposing inner holes of different sizes and disposing different inner hole structures (opening holes or closed holes) and beneficial effects thereof, related content in the embodiment in FIG. 11 may be referenced. Details are not described herein again.

It should be understood that the metal conducting layer 703 may cover a first surface and a second surface that of the elastic conductive connection component and that are disposed opposite to each other in a height H direction. The first surface is electrically connected to a first element 10 and the second surface is electrically connected to a second element 20. In some embodiments, the metal conducting layer may further cover at least one side surface of the elastic conductive connection component, where the side surface includes two surfaces that are disposed opposite to each other along a width W direction and two surfaces that are disposed opposite to each other along a length L direction.

The surface of the elastic conductive connection component is coated with a metal conducting layer, and this can enhance conductivity and reduce the ground resistance. In addition, a risk of increased ground resistance due to a fracture of the nanowire can also be reduced. For example, when the deformation amount exceeds a specific value, the nanowire may break or even fall off, and the surface is coated with a conducting layer, which can avoid a problem of ground resistance instability caused by the nanowire that may break or even fall off.

FIG. 13 shows another schematic cross-sectional view of an elastic conductive connection component 70 provided in an embodiment of this application along an HW plane (a plane formed in a height H direction and a width W direction).

A difference between the elastic conductive connection component shown in FIG. 13 and the elastic conductive connection component shown in FIG. 8 lies in that, the elastic conductive connection component shown in FIG. 13 is covered with a metal conducting layer 703, and descriptions of the metal conducting layer 703 may be referenced from the related descriptions of the embodiment in FIG. 12. In addition, a first surface and a second surface of the elastic conductive connection component shown in FIG. 13 that are disposed along a height H direction are electrically connected through a through hole 704, and the through hole 704 is electroplated or electroless plated with a metal layer, or the through hole is coated with a nanowire. It should be understood that a size of the electroplated or electroless metal layer is different from that of the coated nanowire.

Related content in the embodiments in FIG. 8 and FIG. 9 may be cited for descriptions of shapes, sizes and coated nanowires of the inner holes 702, and corresponding beneficial effects. Details are not described herein again. In some embodiments, similar to the embodiment in FIG. 11, the inner hole in the embodiment in FIG. 13 may also have different sizes, or the inner hole includes both an opening hole and a closed hole, or positions of the opening hole and the closed hole are different. For descriptions of disposing inner holes of different sizes and disposing different inner hole structures (opening holes or closed holes) and beneficial effects thereof, related content in the embodiment in FIG. 11 may be referenced. Details are not described herein again.

The elastic conductive connection component is electrically connected to the first surface and the second surface along a height H direction through a through hole 704. A metal layer is attached to the through hole 704 through electroplating or electroless plating, or the through hole is coated with the nanowire, so that conductivity of the elastic conductive connection component can be enhanced, to avoid the problem of unstable ground resistance caused by the fracture and falling off of the nanowire on the hole wall.

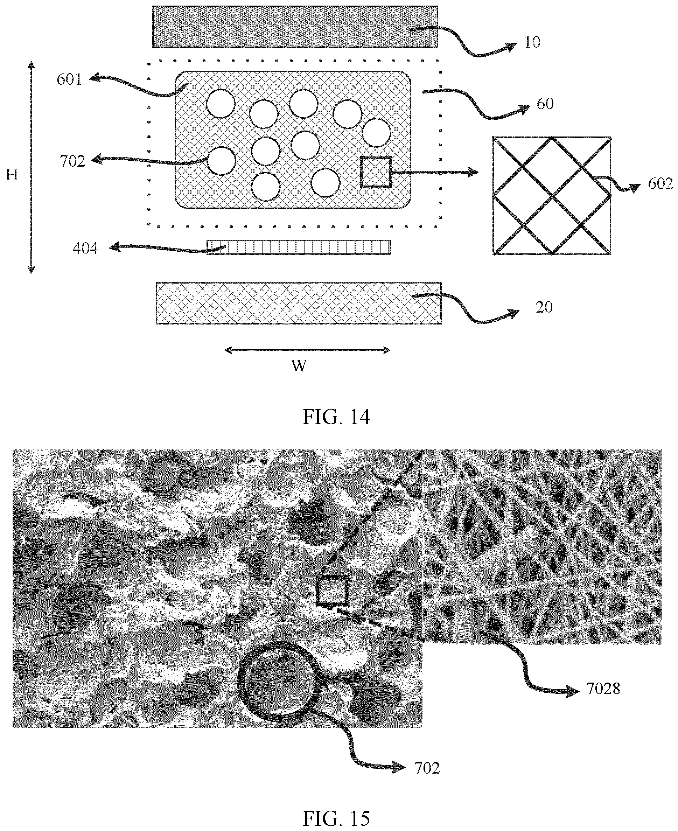

FIG. 14 shows another schematic cross-sectional view of an elastic conductive connection component 70 provided in an embodiment of this application along an HW plane (a plane formed in a height H direction and a width W direction).

A difference between the elastic conductive connection component shown in FIG. 14 and the elastic conductive connection component shown in FIG. 8 lies in that a foam of the elastic conductive connection component shown in FIG. 14 is a metallization foam, where the metallization foam is formed in a form of electroplating or electroless plating (similar to the metallization foam described in the embodiments of FIG. 7A and FIG. 7B).

Related content in the embodiments in FIG. 8 and FIG. 9 may be cited for descriptions of shapes, sizes and coated nanowires of the inner holes 702, and beneficial effects. Details are not described herein again. In some embodiments, similar to the embodiment in FIG. 11, the inner hole in the embodiment in FIG. 14 may also have different sizes, or the inner hole includes both an opening hole and a closed hole, or positions of the opening hole and the closed hole are different. For descriptions of disposing inner holes of different sizes and disposing different inner hole structures (opening holes or closed holes) and beneficial effects thereof, related content in the embodiment in FIG. 11 may be referenced. Details are not described herein again.

The elastic conductive connection component may further include an electroplated or electroless plating foam 601, and the foam 601 includes a grid-shaped conducting structure 602 and an inner hole 702 coated with a nanowire.

The foam of the elastic conductive connection component is a metallization foam, where the metallization foam is formed in a form of electroplating or electroless plating, which can enhance conductivity of the elastic conductive connection component, and avoid a problem of unstable ground resistance caused by the fracture and falling off of the nanowire on the hole wall of the inner hole.

FIG. 15 schematically shows a photograph of a part of a foam of an elastic conductive connection component having an inner hole and coated with a nanowire in the inner hole under an electron microscope according to an embodiment of this application. It can be learned that the foam includes an inner hole 702 and a wall of the inner hole is coated with a nanowire 7028.

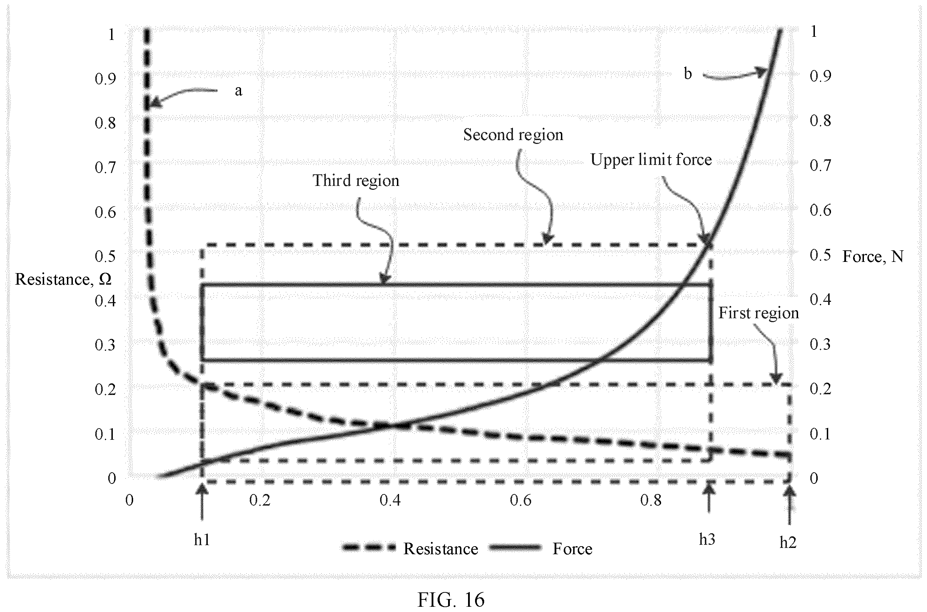

FIG. 16 schematically shows a DFR curve of an elastic conductive connection component having an inner hole and the inner hole coated with a nanowire according to the embodiment in FIG. 15.

For a first region satisfying a low resistance requirement (for example, less than 0.2 ohms), a deformation amount is about 0.1 mm to 1 mm. For a second region satisfying a force requirement (for example, less than 0.5 N), a deformation amount is about 0.1 mm to 0.87 mm. Therefore, the deformation amount that meets both the resistance requirement and the force requirement ranges from 0.1 mm to 0.87 mm.

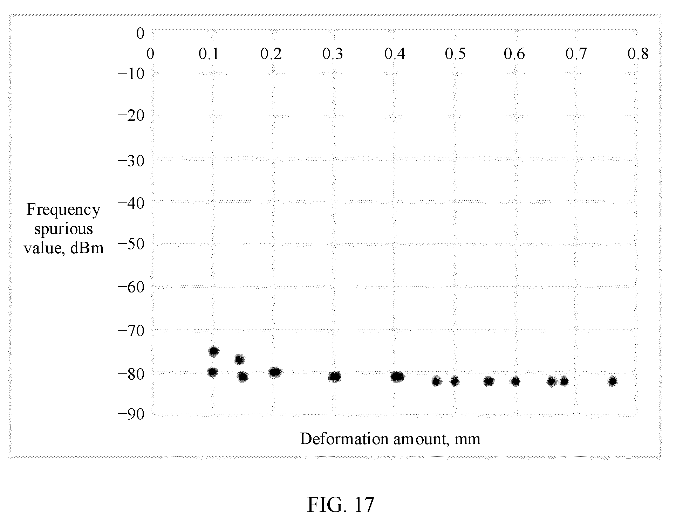

FIG. 17 schematically provides a frequency spurious curve of an elastic conductive connection component having an inner hole and having an inner hole coated with a nanowire according to the embodiment in FIG. 15. It can be learned that in a wide range of deformation amount (for example, between 0.1 mm and 0.8 mm), frequency spurious values of the elastic conductive connection component are all less than -80 dBm.

The elastic conductive connection component having an inner hole and the inner hole coated with a nanowire may have a wider working range. For a grounding scenario of a display assembly(for example, a flexible display), a force (or a rebound force) on the display can be reduced, a bright spot, a bright line, and a film print generated on the display can be reduced, and a risk of screen failure can also be reduced. In addition, in a scenario in which an antenna is grounded, a low-resistance continuity requirement of an antenna and a radio frequency can be met, and a low-frequency spurious characteristic is provided.

To improve a binding force between a foam and a nanowire, a suitable solvent can be used in a preparation process. The solvent expands a volume of the foam to more than twice, and after solidifying, the volume of the foam returns to an initial size, so that a density of a conducting layer of the solidified foam can be increased. A bonding force between the conducting layer and the foam can also be improved, thereby further reducing the ground resistance.

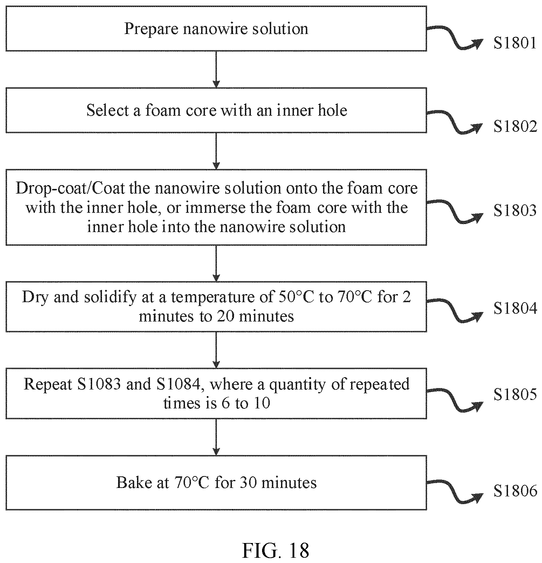

As shown in FIG. 18, an embodiment of this application provides a preparation method of an elastic conductive connection component. The method includes the following steps.

S1801: Prepare nanowire solution.

In some embodiments, a diameter of a nanowire may be 10 nm to 100 nm, and a length-diameter ratio may range from 1000:1 to 5000:1.

In some embodiments, the nanowire may be made of at least one of conductive materials such as nano-copper, nano-silver, nano-nickel, and nano-gold.

In some embodiments, the diameter of the nanowire is 70 nm to enhance conductivity, reduce falling off of the nanowire due to a force on the foam, and avoid generation of a high frequency spurious.

In some embodiments, a foam expansion agent may be used as a nanowire solution solvent, so that the foam is first expanded in volume and then compounded in a drop coating/coating process, and after solidifying and molding, shrinks in volume to form a nanowire conducting layer with a high density and a higher binding force. This resolves problems of resistance instability and frequency spurious caused by the falling off and fractures of a coating layer in the elastic conductive connection component in the conventional technology.

S1802: Select a foam with an inner hole. A size of the inner hole of the foam may be 20 um to 500 um, and a material of the foam may be silica gel gaskets or the like. In some embodiments, to increase a force rebound working range of the foam, the size of the inner hole of the foam may be 100 um.

S1803: Drop-coat/coat the nanowire solution onto the foam with the inner hole, or immerse the foam with the inner hole into the nanowire solution.

S1804: Dry and solidify the elastic conductive connection component obtained in S1803 at 50°C to 70°C for 2 minutes to 20 minutes.

S1805: Repeat S1803 and S1804 for a plurality of times, where a quantity of times is 6 to 10.

S1806: Bake the elastic conductive connection component obtained in S1805 at 70°C for 30 minutes.

To implement surface mounting on the elastic conductive connection component, that is, to resolve an SMT (Surface Mounted Technology, surface mounted technology) problem, for the elastic conductive connection component provided in this embodiment of this application, a surface (including a first surface and a second surface that are disposed opposite to each other in a height H direction) of the elastic conductive connection component may be coated with a solderable nanowire to form a solderable conducting layer, and the surface mounted problem of the elastic conductive connection component is resolved.

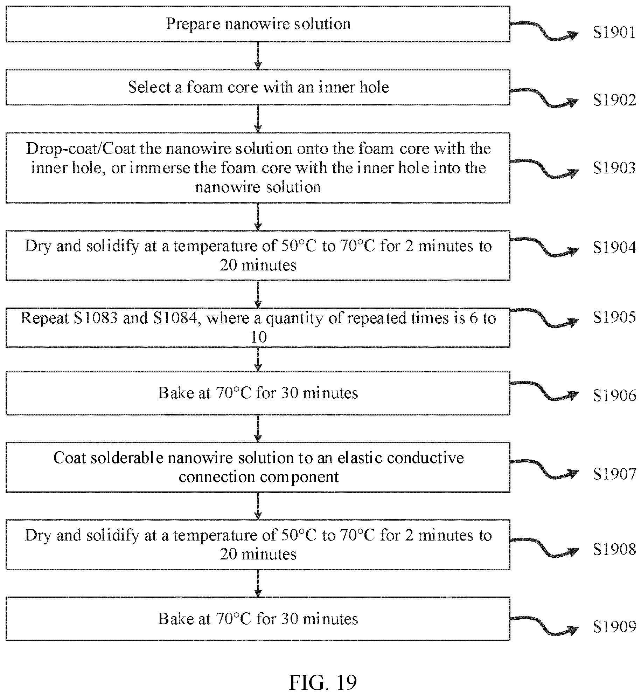

As shown in FIG. 19, an embodiment of this application provides a preparation method of a surface mounted elastic conductive connection component. The method includes the following steps.

S1901 to S1905: S1901 to S1905 may be referenced from related content of S1801 to S1805 of the preparation method of the elastic conductive connection component in the embodiment in FIG. 18. Details are not described herein again.

S1906: Coat solderable nanowire solution to the elastic conductive connection component. The nanowire may be a nano-material having a solderable characteristic, for example, at least one of nano-copper, nano-tin, and nano-gold.

S1907: Dry and solidify the elastic conductive connection component with the surface coated with solderable nanowire solution at 50°C to 70°C for 2 minutes to 20 minutes.

S1908: Bake the elastic conductive connection component coated with the solderable nanowire solution at 70°C for 30 minutes.

By coating the solderable nanowire solution on the foam, the elastic conductive connection component can be surface mounted, and can be soldered to a main board for grounding the main board.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. An elastic conductive connection component, wherein the elastic conductive connection component is configured to connect a first element and a second element, and the elastic conductive connection component comprises:
a foam, wherein the foam has a first surface and a second surface that are disposed opposite to each other in a first direction, the first surface is configured to be electrically connected to the first element, the second surface is electrically connected to the second element, and the foam comprises an inner hole; and
a nanowire, wherein the nanowire is attached to a hole wall of the inner hole.

2. The elastic conductive connection component according to claim 1, wherein the inner hole comprises a closed hole.

3. The elastic conductive connection component according to claim 2, wherein a diameter of the inner hole is 20 um to 500 um.

4. The elastic conductive connection component according to claim 2 or 3, wherein a density of the elastic conductive connection component is less than or equal to 200 kg/m².

5. The elastic conductive connection component according to any one of claims 2 to 4, wherein a diameter of the nanowire is 10 um to 100 nm.

6. The elastic conductive connection component according to any one of claims 2 to 5, wherein a ratio of a length to the diameter of the nanowire ranges from 1000: 1 to 5000: 1.

7. The elastic conductive connection component according to any one of claims 2 to 6, wherein the nanowire is at least one of a silver nanowire, a copper nanowire, a carbon nanowire, and a gold nanowire.

8. The elastic conductive connection component according to any one of claims 2 to 7, wherein the elastic conductive connection component further comprises a conductive fabric, the conductive fabric covers a surface of the foam, and the surface of the foam comprises the first surface and the second surface that are disposed opposite to each other in the first direction of the foam.

9. The elastic conductive connection component according to claim 8, wherein the first surface and the second surface are electrically connected to each other through a through hole, a hole wall of the through hole is attached with a metal conducting layer or attached with the nanowire.

10. The elastic conductive connection component according to any one of claims 2 to 7, wherein the foam is a three-dimensional mesh structure, and the mesh structure is attached with a metal conducting layer.

11. An electronic device, wherein the electronic device comprises a first element, a second element, and the elastic conductive connection component according to any one of claims 1 to 10.

12. The electronic device according to claim 11, wherein the electronic device further comprises a conductive adhesive, the conductive adhesive is disposed between a first surface and the first element, and the conductive adhesive is disposed between a second surface and the second element.

13. The electronic device according to claim 11 or 12, wherein the first element is a middle frame, and the second element is at least one of an antenna part, a display assembly, a shielding cover, or a camera module.
